# EUROPEAN PATENT APPLICATION

(11) **EP 4 823 248 A1**
(43) Date of publication of application: **14.10.2026**
(21) Application number: 24900667.7
(22) Date of filing: 05.12.2024
(51) Int. Cl.: H05K 1/11, H05K 1/02, H05K 3/40

(54) **THROUGH-ELECTRODE SUBSTRATE AND METHOD FOR MANUFACTURING THROUGH-ELECTRODE SUBSTRATE**

(30) Priority: 05.12.2023 JP 2023205616; 10.05.2024 JP 2024077561
(71) Applicant: Dai Nippon Printing Co., Ltd., Tokyo 162-8001 (JP)
(72) Inventor: KURAMOCHI, Satoru, Tokyo 162-8001 (JP); TAI, Takahiro, Tokyo 162-8001 (JP); FUJIMOTO, Koji, Tokyo 162-8001 (JP)
(74) Representative: Müller-Boré & Partner Patentanwälte PartG mbB
(86) International application number: PCT/JP2024/043050
(87) International publication number: WO 2025/121374

(57) **Abstract**

A through-via substrate includes a substrate having a first surface, a second surface located opposite to the first surface, and a plurality of through holes extending from the first surface to the second surface, and a plurality of through vias extending from the first surface to the second surface through the through holes. Each of the plurality of through vias includes a plurality of internal portions located inside a respective plurality of the through holes, a first portion located at the first surface and connected to the plurality of internal portions, and a second portion located at the second surface and connected to the plurality of internal portions. Each of the first portions of the plurality of through vias has an outline surrounding the respective plurality of through holes in plan view.

## Description

### Technical Field

Embodiments of the present disclosure relate to a through-via substrate and a method of manufacturing a through-via substrate.

### Background Art

The through-via substrate is used in various applications. A through-via substrate is a member that includes a substrate having a first surface and a second surface, a through hole formed in the substrate, and a through via located in the through hole. The through-via substrate is used as, for example, an interposer. An interposer is a member interposed between two electrical components. For example, a through-via substrate is interposed between two LSI chips in a thickness direction. A through-via substrate may sometimes be interposed between an element, such as an LSI chip, and a mounting substrate, such as a motherboard. The through-via substrate is also used as a member constituting a passive component such as an inductor or a capacitor.

For example, as disclosed in Patent Document 1, a through via of a through-via substrate has various structures. A first example of a through via is an example in which the entire through hole is filled with a conductive material such as copper. The second example is an example in which a layer of a conductive material such as copper is formed on a wall surface of a through hole. The third example is an example in which a layer of a conductive material such as copper is formed on a wall surface of a through hole and in which a layer of a conductive material that closes the through hole is formed along a first surface or a second surface of a substrate. In the second and third examples, a space of the through hole where the conductive material is not present is filled with a resin material.

### Citation List

### Patent Literature

PTL 1: International Publication No. 2022/173057

### Summary of Invention

### Technical Problem

There is a need to increase the maximum value of a current (hereinafter also referred to as "allowable current") that can flow through a through via. In the through via of the first example, the larger the dimension of the through hole in the planar direction, the higher the allowable current of the through via. However, the larger the dimension of the through hole, the more likely defects such as voids are to occur in the conductive material filled in the through hole. Also in the through vias of the second example and the third example, as the dimension of the through hole in the planar direction becomes larger, the allowable current of the through via becomes higher. As the dimension of the through hole becomes larger, defects such as voids are more likely to occur in the resin material filled in the through hole.

An object of embodiments of the present disclosure is to provide a through-via substrate and a method of manufacturing a through-via substrate that can effectively solve such a problem.

### Solution to Problem

Embodiments of the present disclosure relate to the following [1] to [23].

[1] A through-via substrate comprising:
   a substrate having a first surface, a second surface located opposite to the first surface, and a plurality of through holes extending from the first surface to the second surface; and
   a plurality of through vias extending from the first surface to the second surface through the through holes,
   wherein each of the plurality of through vias includes a plurality of internal portions located inside a respective plurality of the through holes, a first portion located at the first surface and connected to the plurality of internal portions, and a second portion located at the second surface and connected to the plurality of internal portions, and
   wherein each of the first portions of the plurality of through vias has an outline surrounding the respective plurality of through holes in plan view.
[2] In the through-via substrate according to [1], each of the plurality of through holes may have a wall surface having a first end connected to the first surface, a second end connected to the second surface, and a minimum portion located between the first end and the second end. Each of the plurality of through holes may have a minimum dimension at the minimum portion, the minimum dimension being a minimum value of a dimension of the through hole in a planar direction of the first surface. Each of the plurality of internal portions may include a closing portion that closes the through hole at least at the minimum portion, a third portion located on the wall surface between the first portion and the closing portion, and a fourth portion located on the wall surface between the second portion and the closing portion.
[3] In the through-via substrate according to [2], the closing portion may have a first closing surface and a second closing surface. The first closing surface may be a surface of the closing portion, the surface facing toward the first surface. The second closing surface may be a surface of the closing portion, the surface facing toward the second surface. The through via may have a first distance that is a maximum value of a distance from the first surface to the first closing surface in a thickness direction of the substrate, and a second distance that is a maximum value of a distance from the second surface to the second closing surface in the thickness direction of the substrate. A ratio of the first distance to a thickness of the substrate may be 0.10 or more. A ratio of the second distance to the thickness of the substrate may be 0.10 or more.
[4] The through-via substrate according to [2] or [3] may comprise a plurality of internal resins located inside each of the plurality of through holes. Each of the plurality of internal resins may include a first internal resin located inside the third portion and a second internal resin located inside the fourth portion.
[5] In the through-via substrate according to [1], each of the plurality of through holes may have a wall surface having a first end connected to the first surface and a second end connected to the second surface. Each of the plurality of internal portions may be located on the wall surface so as to extend from the first end to the second end. The through-via substrate may include a plurality of internal resins located inside a respective one of the plurality of internal portions of the through via in each of the plurality of through holes.
[6] In the through-via substrate according to [5], each of the plurality of through holes may include a minimum portion located between the first end and the second end. Each of the plurality of through holes may have a minimum dimension at the minimum portion, the minimum dimension being a minimum value of a dimension of the through hole in a planar direction of the first surface.
[7] In the through-via substrate according to any one of [4] to [6], the first portion of each of the plurality of through vias may have a plurality of openings in which the internal resins are located.
[8] In the through-via substrate according to [1], a ratio of a thickness of the internal portion to a thickness of the substrate may be 0.80 or more and 1.20 or less.
[9] The through-via substrate according to any one of [1] to [8] may comprise a plurality of first conductive layers connected respectively to the first portions of the plurality of through vias, and a first resin layer located between the first portions of the plurality of through vias and the plurality of first conductive layers in a thickness direction of the substrate.
[10] In the through-via substrate according to [9], each of the plurality of first conductive layers may have an outline surrounding the respective plurality of through holes in plan view.
[11] The through-via substrate according to [10] may comprise a plurality of third conductive layers connected to one of the plurality of first conductive layers, and a third resin layer located between one of the plurality of first conductive layers and the plurality of third conductive layers in the thickness direction of the substrate.
[12] In the through-via substrate according to [10] or [11], the plurality of through vias may include a first through via and a second through via adjacent to the first through via in plan view. One of the first conductive layers connected to the first through via may extend outward beyond the outline of the first portion of the first through via. The first portion of the second through via may extend outward beyond the outline of another one of the first conductive layers connected to the second through via. A portion of the first conductive layer connected to the first through via and a portion of the first portion of the second through via may face each other in the thickness direction of the substrate.
[13] In the through-via substrate according to any one of [9] to [12], the first resin layer may have an opening in which a portion of the first conductive layer is located, the opening having a fourth dimension in plan view. The through hole may have a first dimension at the first surface. The fourth dimension may be greater than the first dimension.
[14] A through-via substrate comprising:
   a substrate having a first surface, a second surface located opposite to the first surface, and a plurality of through holes extending from the first surface to the second surface;
   a plurality of through vias extending from the first surface to the second surface through the through holes; and
   a first wiring layer located at the first surface and including at least one insulating layer and at least one conductive layer,
   wherein each of the plurality of through vias includes a plurality of internal portions located inside a respective plurality of the through holes,
   wherein a ratio of a thickness of the internal portion to a thickness of the substrate is 0.80 or more and 1.20 or less,
   wherein the at least one insulating layer includes a first resin layer located on the first surface,
   wherein the first resin layer has a plurality of openings, each of the plurality of openings overlapping the internal portion in plan view,
   wherein the first resin layer overlaps a boundary between a wall surface of the through hole and the internal portion in plan view, and
   wherein the at least one conductive layer includes a conductive layer electrically connected to the plurality of internal portions.
[15] In the through-via substrate according to [14], the at least one conductive layer may include a first conductive layer connected to the plurality of internal portions in the plurality of openings of the first resin layer. The first conductive layer may be the conductive layer electrically connected to the plurality of internal portions.
[16] In the through-via substrate according to [14], the at least one conductive layer may include a plurality of first conductive layers each connected to a respective one of the plurality of internal portions in a respective one of the plurality of openings of the first resin layer, and the conductive layer, which is electrically connected to the plurality of first conductive layers.
[17] In the through-via substrate according to any one of [1] to [16], the plurality of through vias may be arranged at a first pitch in a planar direction of the first surface. The respective through holes in which the plurality of internal portions included in one of the through vias are located may be arranged at a second pitch in a planar direction of the first surface. A ratio of the first pitch to the second pitch may be 2.0 or more.
[18] In the through-via substrate according to [17], the ratio of the first pitch to the second pitch may be 5.0 or less.
[19] In the through-via substrate according to [17] or [18], the through hole may have a first dimension at the first surface. A ratio of the second pitch to the first dimension may be 1.5 or more.
[20] In the through-via substrate according to [19], the first dimension may be 50 µm or more and 100 µm or less.
[21] A mounting substrate comprising:
   the through-via substrate according to any one of [1] to [20]; and
   an element electrically connected to the plurality of through vias of the through-via substrate.
[22] A method of manufacturing a through-via substrate, comprising:
   a step of preparing a substrate having a first surface, a second surface located opposite to the first surface, and a plurality of through holes extending from the first surface to the second surface; and
   a through-via forming step of forming a plurality of through vias extending from the first surface to the second surface through the through holes,
   wherein each of the plurality of through vias includes a plurality of internal portions located inside a respective plurality of the through holes, a first portion located at the first surface and connected to the plurality of internal portions, and a second portion located at the second surface and connected to the plurality of internal portions, and
   wherein each of the first portions of the plurality of through vias has an outline surrounding the respective plurality of through holes in plan view.
[23] A method for manufacturing a through-via substrate, the method comprising:
   a step of preparing a substrate having a first surface, a second surface located opposite to the first surface, and a plurality of through holes extending from the first surface to the second surface;
   a through-via forming step of forming a plurality of through vias extending from the first surface to the second surface through the through holes; and
   a step of forming a first wiring layer that is located at the first surface and that includes at least one insulating layer and at least one conductive layer,
   wherein each of the plurality of through vias includes a plurality of internal portions located inside a respective plurality of the through holes,
   wherein each of the plurality of internal portions is a filled via,
   wherein the at least one insulating layer includes a first resin layer located on the first surface,
   wherein the first resin layer has a plurality of openings, each of the plurality of openings overlapping the internal portion in plan view,
   wherein the first resin layer overlaps a boundary between a wall surface of the through hole and the internal portion in plan view, and
   wherein the at least one conductive layer includes a conductive layer electrically connected to the plurality of internal portions.

### Advantageous Effects of Invention

According to the embodiments of the present disclosure, the allowable current of a through via can be increased while suppressing the occurrence of defects such as voids.

### Brief Description of Drawings

[Fig. 1] Fig. 1 is a plan view illustrating a through-via substrate according to an embodiment.
[Fig. 2] Fig. 2 is a plan view illustrating a portion of the through-via substrate of Fig. 1.
[Fig. 3] Fig. 3 is a cross-sectional view of the through-via substrate taken along line III-III of Fig. 2.
[Fig. 4] Fig. 4 is a cross-sectional view illustrating an example of each through via of the through-via substrate.
[Fig. 5] Fig. 5 is a cross-sectional view illustrating an example of a through hole of a substrate.
[Fig. 6] Fig. 6 is a cross-sectional view illustrating an example of each through via.
[Fig. 7] Fig. 7 is a cross-sectional view illustrating an example of the dimensions of each through via.
[Fig. 8] Fig. 8 is a cross-sectional view illustrating an example of a step of preparing a substrate.
[Fig. 9] Fig. 9 is a cross-sectional view illustrating an example of a seed-layer forming step.
[Fig. 10] Fig. 10 is a cross-sectional view illustrating an example of a plating-layer forming step.
[Fig. 11] Fig. 11 is a cross-sectional view illustrating an example of the plating-layer forming step.
[Fig. 12] Fig. 12 is a cross-sectional view illustrating an example of the plating-layer forming step.
[Fig. 13] Fig. 13 is a cross-sectional view illustrating an example of a step of removing a portion of the seed layer.
[Fig. 14] Fig. 14 is a cross-sectional view illustrating an example of a resin-layer forming step.
[Fig. 15] Fig. 15 is a cross-sectional view illustrating a modification of each through via of the through-via substrate.
[Fig. 16] Fig. 16 is a cross-sectional view illustrating a modification of each through via of the through-via substrate.
[Fig. 17] Fig. 17 is a cross-sectional view illustrating a modification of each through via of the through-via substrate.
[Fig. 18] Fig. 18 is a cross-sectional view illustrating a modification of each through via of the through-via substrate.
[Fig. 19] Fig. 19 is a plan view illustrating a modification of the through-via substrate.
[Fig. 20] Fig. 20 is a cross-sectional view of the through-via substrate taken along line XX-XX of Fig. 19.
[Fig. 21] Fig. 21 is a cross-sectional view of the through-via substrate taken along line XXI-XXI of Fig. 19.
[Fig. 22] Fig. 22 is a cross-sectional view illustrating a modification of the through-via substrate.
[Fig. 23] Fig. 23 is a cross-sectional view illustrating a modification of the through-via substrate.
[Fig. 24] Fig. 24 is a cross-sectional view illustrating a modification of the through-via substrate.
[Fig. 25] Fig. 25 is a cross-sectional view illustrating a modification of the through-via substrate.
[Fig. 26] Fig. 26 is a cross-sectional view illustrating a modification of the through-via substrate.
[Fig. 27] Fig. 27 is a plan view illustrating a modification of the through-via substrate.
[Fig. 28] Fig. 28 is a diagram illustrating examples of products on which the through-via substrate is mounted.
[Fig. 29] Fig. 29 is a table illustrating the evaluation results of Examples 1 to 5.
[Fig. 30] Fig. 30 is a cross-sectional view illustrating a modification of the through-via substrate.
[Fig. 31] Fig. 31 is a plan view illustrating a modification of the through-via substrate.
[Fig. 32] Fig. 32 is a cross-sectional view of the through-via substrate taken along line XXXII-XXXII of Fig. 31.
[Fig. 33] Fig. 33 is a plan view illustrating a modification of the through-via substrate.
[Fig. 34] Fig. 34 is a cross-sectional view of the through-via substrate taken along line XXXIV-XXXIV of Fig. 33.
[Fig. 35] Fig. 35 is a cross-sectional view illustrating a modification of the through-via substrate.
[Fig. 36] Fig. 36 is a cross-sectional view illustrating a modification of the through-via substrate.
[Fig. 37] Fig. 37 is a cross-sectional view illustrating a modification of the through-via substrate.
[Fig. 38] Fig. 38 is a cross-sectional view illustrating a modification of the through-via substrate.

### Description of Embodiments

A configuration of a through-via substrate and a method of manufacturing the through-via substrate will be described in detail with reference to the drawings. The embodiments described below are examples of the embodiments of the present disclosure, and the present disclosure is not limited to these embodiments. In the present specification, terms such as "substrate", "base material", "sheet", and "film" are not distinguished from one another based solely on the difference in designation. For example, the term "substrate" is a concept that includes a member that can be referred to as a sheet or a film. The term "surface" refers to a surface that coincides with the planar direction of a target plate-shaped member when the target plate-shaped member is viewed as a whole and from a broad perspective. The normal direction used for a plate-shaped member refers to the normal direction with respect to a surface of the member. For example, terms such as "parallel" and "orthogonal", values of lengths and angles, and the like used in the present specification to specify shapes, geometric conditions, and degrees thereof are not bound by strict meanings, and are interpreted to include a range in which similar functions can be expected.

In the present specification, when a plurality of upper limit value candidates and a plurality of lower limit value candidates are listed for a certain parameter, the numerical range of the parameter may be defined by combining any one of the upper limit value candidates and any one of the lower limit value candidates. For example, consider the case where the following is described: "The parameter B is, for example, A1 or more, and may be A2 or more, or A3 or more. The parameter B is, for example, A4 or less, and may be A5 or less, or A6 or less." In this case, the numerical range of the parameter B may be A1 or more and A4 or less, A1 or more and A5 or less, A1 or more and A6 or less, A2 or more and A4 or less, A2 or more and A5 or less, A2 or more and A6 or less, A3 or more and A4 or less, A3 or more and A5 or less, or A3 or more and A6 or less.

In the drawings referred to in the present embodiment, the same portions or portions having similar functions are denoted by the same reference signs or similar reference signs, and repeated descriptions thereof may be omitted. In addition, the dimensional ratio in the drawings may differ from the actual ratio for convenience of description, or a portion of the configuration may be omitted from the drawings.

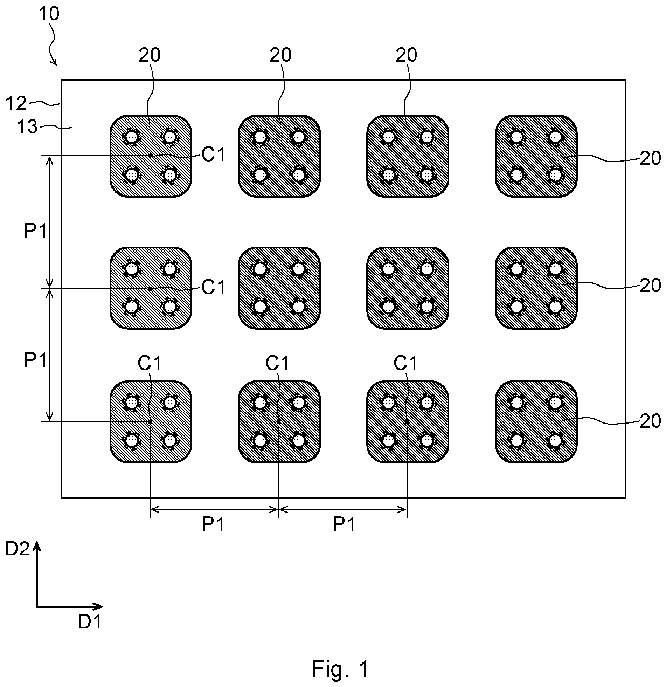

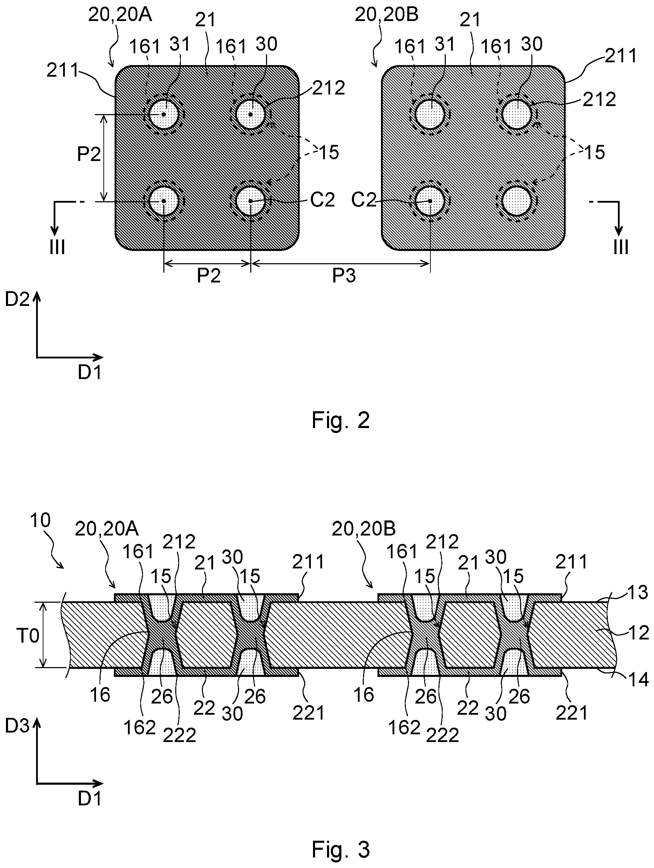

Embodiments of the present disclosure will be described. Fig. 1 is a plan view illustrating an example of the through-via substrate 10. Fig. 2 is a plan view illustrating a portion of the through-via substrate 10 of Fig. 1. Fig. 3 is a cross-sectional view of the through-via substrate 10 taken along line III-III of Fig. 2.

The through-via substrate 10 includes a substrate 12 and a plurality of through vias 20. The substrate 12 has a first surface 13 and a second surface 14 located opposite to the first surface 13 in the thickness direction of the substrate 12. The thickness direction is also referred to as a third direction D3. The substrate 12 further has a plurality of through holes 15 extending from the first surface 13 to the second surface 14. Each of the plurality of through vias 20 extends from the first surface 13 to the second surface 14 through the through holes 15.

As illustrated in Fig. 1, the plurality of through vias 20 may be arranged in one of planar directions of the first surface 13. For example, the plurality of through vias 20 may be arranged in a first direction D1. The first direction D1 is one of the planar directions of the first surface 13. For example, the plurality of through vias 20 may also be arranged in a second direction D2 different from the first direction D1. The second direction D2 is also one of the planar directions of the first surface 13. The second direction D2 may be orthogonal to the first direction D1.

The plurality of through vias 20 may be arranged at a first pitch P1 in one of the planar directions of the first surface 13. For example, the plurality of through vias 20 may be arranged at the first pitch P1 in the first direction D1 and the second direction D2. The first pitch P1 is the distance between center points C1 of two adjacent through vias 20 in plan view. The term "plan view" refers to viewing an object along a normal direction of the first surface 13.

The first pitch P1 is, for example, 200 µm or more, and may be 400 µm or more, or 600 µm or more. The first pitch P1 is, for example, 3000 µm or less, may be 2000 µm or less, and may be 1000 µm or less.

The first pitch P1 may vary depending on the position in the first direction D1 or the position in the second direction D2. When the numerical values of the plurality of first pitches P1 are measured, it is determined, based on the smallest value among the plurality of first pitches P1, whether the first pitch P1 satisfies the numerical range described in the present specification.

The substrate 12 and the through vias 20 will be described in detail.

### (Substrate)

The substrate 12 includes an inorganic material having insulating properties. For example, the substrate 12 is a glass substrate, a quartz substrate, a sapphire substrate, a resin substrate, a silicon substrate, a silicon carbide substrate, an alumina (Al₂O₃) substrate, an aluminum nitride (AlN) substrate, a zirconia (ZrO₂) substrate, or the like, or a laminate of these substrates. The substrate 12 may partially include a substrate made of a conductive material, such as an aluminum substrate or a stainless steel substrate.

Examples of the glass used for the substrate 12 include alkali-free glass. Alkali-free glass is a glass that does not contain alkali components such as sodium and potassium. The alkali-free glass contains, for example, boric acid instead of an alkali component. In addition, the alkali-free glass contains, for example, an alkaline earth metal oxide such as calcium oxide or barium oxide.

A thickness T0 of the substrate 12 is, for example, 100 µm or more, and may be 200 µm or more, or may be 300 µm or more. The thickness T0 of the substrate 12 is, for example, 800 µm or less, and may be 600 µm or less, or may be 400 µm or less.

As illustrated in Figs. 2 and 3, each through hole 15 has a wall surface 16 extending from the first surface 13 to the second surface 14. The wall surface 16 has a first end 161 and a second end 162. The first end 161 is a portion of the wall surface 16, the portion being connected to the first surface 13. The second end 162 is a portion of the wall surface 16, the portion being connected to the second surface 14. The first end 161 and the second end 162 may each have a circular outline in plan view.

### (Through Via)

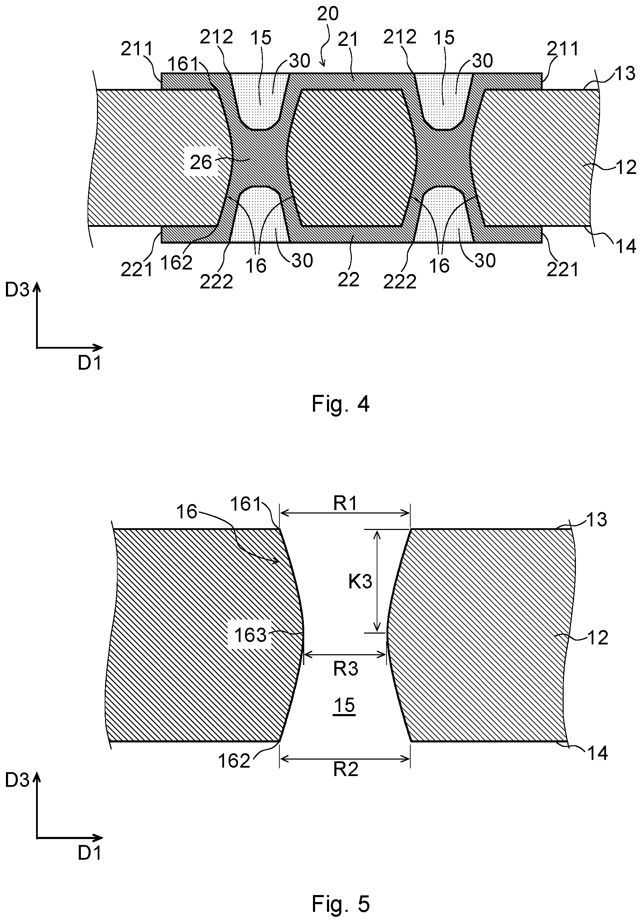

Fig. 4 is a cross-sectional view illustrating an example of each through via 20. As illustrated in Figs. 2 to 4, each of the plurality of through vias 20 includes one first portion 21, one second portion 22, and a plurality of internal portions 26. The internal portions 26 are portions of the conductive material constituting the through via 20 that are located inside the through holes 15. Each of the plurality of internal portions 26 is located inside the corresponding through hole 15. In other words, the internal portions 26 are located inside the through holes 15 in a one-to-one correspondence. Therefore, each of the plurality of through vias 20 includes the one first portion 21, the one second portion 22, and the plurality of internal portions 26, which are located inside their respective plurality of through holes 15. In the present embodiment, each of the plurality of through vias 20 includes the one first portion 21, the one second portion 22, and the four internal portions 26 that are located inside their respective four through holes 15.

A structure in which each of the through vias 20 includes the plurality of internal portions 26 located inside their respective plurality of through holes 15 is also referred to as a multi-via structure.

The number of the through holes 15 overlapping the one first portion 21 in plan view is, for example, two or more, and may be four or more. The number of the through holes 15 overlapping the one first portion 21 in plan view is, for example, 16 or less, and may be 12 or less, may be 9 or less, may be 8 or less, or may be 6 or less.

The plurality of internal portions 26 of each of the through vias 20 are connected to the one first portion 21 at the first surface 13 and are connected to the one second portion 22 at the second surface 14. The first portion 21 is located on the first surface 13. The second portion 22 is located on the second surface 14.

The first portion 21 has an outline 211. The outline 211 is the outer edge of the first portion 21 in plan view. As illustrated in Fig. 2, the outline 211 of the first portion 21 of each of the plurality of through vias 20 may surround the first ends 161 of the wall surfaces 16 of the plurality of through holes 15 in plan view. In the entire region of the outline 211, the distance from the center point C1 to the outline 211 in plan view may be greater than the distance from the center point C1 to each of the first ends 161 in plan view.

The plurality of through holes 15 in which the plurality of internal portions 26 included in one of the through vias 20 are located may be arranged at a second pitch P2 in one of the planar directions of the first surface 13. For example, the plurality of through holes 15 may be arranged at the second pitch P2 in the first direction D1 and the second direction D2. The second pitch P2 is the distance between center points C2 of two adjacent through holes 15 in plan view. In the present embodiment, the plurality of through holes 15 in which the plurality of internal portions 26 included in one of the through vias 20 are located are surrounded by the outline of the one first portion 21 in plan view.

The second pitch P2 is, for example, 80 µm or more, and may be 100 µm or more, 125 µm or more, 150 µm or more, 175 µm or more, 200 µm or more, 300 µm or more, or 350 µm or more. The second pitch P2 is, for example, 1000 µm or less, may be 700 µm or less, and may be 500 µm or less. The smaller the second pitch P2, the higher the distribution density of the through holes 15, and thus, the higher the allowable current of each of the through vias 20. The larger the second pitch P2, the more easily the stress generated in the internal portions 26 is relieved, and thus, the higher the reliability of the through-via substrate 10.

The second pitch P2 is smaller than the first pitch P1. A ratio P1/P2 that is the ratio of the first pitch P1 to the second pitch P2 is, for example, 2.0 or more, and may be 2.5 or more, or may be 3.0 or more. The ratio P1/P2 is, for example, 5.0 or less, and may be 4.5 or less, or may be 4.0 or less.

In Fig. 2, reference sign P3 denotes the shortest distance between the through holes 15 of two adjacent through vias 20. The two adjacent through vias 20 are also referred to as a first through via 20A and a second through via 20B. The shortest distance P3 is measured between the center point C2 of the through hole 15 of the first through via 20A and the center point C2 of the through hole 15 of the second through via 20B.

The smaller the difference between the second pitch P2 and the shortest distance P3, the more uniform the distribution density of the through holes 15 in the substrate 12 becomes. The higher the uniformity of the distribution density of the through holes 15, the more suppressed variations in the stress generated in the substrate 12 depending on the position are. A ratio P3/P2 that is the ratio of the shortest distance P3 to the second pitch P2 is, for example, 0.90 or more, may be 0.95 or more, or may be 1.00 or more. The ratio P3/P2 is, for example, 2.00 or less, may be 1.50 or less, and may be 1.20 or less.

The second portion 22 has an outline 221. The outline 221 is the outer edge of the second portion 22 in plan view. Although not illustrated, the outline 221 of the second portion 22 of each of the plurality of through vias 20 may surround the second ends 162 of the wall surfaces 16 of the plurality of through holes 15 in plan view. In the entire region of the outline 221, the distance from the center point C1 to the outline 221 in plan view may be greater than the distance from the center point C1 to each of the second ends 162 in plan view.

The through-via substrate 10 may include a plurality of internal resins 30. Each of the plurality of internal resins 30 is a resin material located inside the corresponding through hole 15. As illustrated in Fig. 3, each of the plurality of internal resins 30 may be disposed in a portion of the internal space of the corresponding through hole 15 where the internal portion 26 is not located.

As illustrated in Figs. 2 to 4, each of the first portions 21 of the plurality of through vias 20 may have a plurality of openings 212 overlapping the through holes 15 in plan view. Each of the plurality of openings 212 may overlap a respective one of the through holes 15. A respective one of the internal resins 30 may be located in each of the openings 212. By forming the plurality of openings 212 in the first portion 21, the stress generated in each of the through vias 20 is more easily relieved.

Each of the second portions 22 of the plurality of through vias 20 may also have a plurality of openings 222 overlapping the through holes 15 in plan view. Each of the plurality of openings 222 may overlap a respective one of the through holes 15. A respective one of the internal resins 30 may be located in each of the openings 222.

The configurations of the through holes 15 and the through vias 20 will be described in detail. Fig. 5 is a cross-sectional view illustrating an example of the through holes 15 of the substrate 12.

Each of the through holes 15 has a first dimension R1 at its first end 161 in the planar direction of the first surface 13. Each of the through holes 15 has a second dimension R2 at its second end 162 in the planar direction of the first surface 13. Each of the through holes 15 may include a minimum portion 163 located between its first end 161 and its second end 162. Each of the through holes 15 has a minimum dimension R3 at its minimum portion 163 in the planar direction of the first surface 13. The minimum portion 163 is defined as a portion of the wall surface 16 where the dimension of the through hole 15 in the planar direction of the first surface 13 is a minimum value.

The first end 161, the second end 162, and the minimum portion 163 may each have a circular outline in plan view. In this case, the first dimension R1, the second dimension R2, and the minimum dimension R3 respectively refer to the diameters of the first end 161, the second end 162, and the minimum portion 163.

The first end 161, the second end 162, and the minimum portion 163 may each have an outline other than a circular shape in plan view. When an outline other than a circular shape is employed, the first dimension R1, the second dimension R2, and the minimum dimension R3 may be equivalent circle diameters. For example, the first dimension R1 may be the diameter of a circle having an area equal to the area enclosed by the outline of the first end 161. For example, the second dimension R2 may be the diameter of a circle having an area equal to the area enclosed by the outline of the second end 162. For example, the minimum dimension R3 may be the diameter of a circle having an area equal to the cross-sectional area of the through hole 15 at the minimum portion 163.

The minimum dimension R3 is smaller than the first dimension R1. The dimension of the through hole 15 may monotonically decrease from its first end 161 to its minimum portion 163. The minimum dimension R3 is smaller than the second dimension R2. The dimension of the through hole 15 may monotonically decrease from its second end 162 to its minimum portion 163.

The minimum dimension R3 is, for example, 40 µm or more, may be 50 µm or more, or may be 60 µm or more. The larger the minimum dimension R3, the higher the allowable current of the internal portions 26 of the through via 20 becomes. The minimum dimension R3 is, for example, 90 µm or less, and may be 80 µm or less, or may be 70 µm or less. The smaller the minimum dimension R3, the more easily a closing portion 25 described later is formed at the minimum portion 163.

The first dimension R1 is, for example, 50 µm or more, and may be 60 µm or more, or may be 70 µm or more. The first dimension R1 is, for example, 100 µm or less, and may be 90 µm or less, or may be 80 µm or less.

A ratio R1/R3 that is the ratio of the first dimension R1 to the minimum dimension R3 is, for example, 2.0 or more, and may be 2.2 or more, or may be 2.5 or more. Since the ratio R1/R3 is 2.0 or more, the allowable current of the internal portions 26 of the through via 20 is sufficiently increased. The ratio R1/R3 is, for example, 3.0 or less, and may be 2.8 or less.

A ratio R2/R3 that is the ratio of the second dimension R2 to the minimum dimension R3 is, for example, 2.0 or more, and may be 2.2 or more, or may be 2.5 or more. Since the ratio R2/R3 is 2.0 or more, the allowable current of the internal portions 26 of the through via 20 is sufficiently increased. The ratio R2/R3 is, for example, 3.0 or less and may be 2.8 or less. The ratio R2/R3 may be the same as or different from the ratio R1/R3.

The difference between the first dimension R1 and the second dimension R2 is preferably small. A ratio R2/R1 that is the ratio of the second dimension R2 to the first dimension R1 is, for example, 0.8 or more and may be 0.9 or more. The ratio R2/R1 is, for example, 1.2 or less, and may be 1.1 or less. By reducing the difference between the first dimension R1 and the second dimension R2, the allowable current of the through via 20 can be efficiently increased while suppressing the occurrence of defects such as voids.

The first dimension R1 is preferably sufficiently smaller than the second pitch P2 of the through holes 15. A ratio P2/R1 that is the ratio of the second pitch P2 to the first dimension R1 is, for example, 1.5 or more, may be 1.6 or more, may be 1.8 or more, and may be 2.0 or more. The ratio P2/R1 is, for example, 3.0 or less, and may be 2.5 or less, or may be 2.3 or less.

As described in the examples, the dimension of each of the through holes 15 may be determined so as to satisfy a condition that "the temperature rise in the through via 20 is 10°C or less when a direct current of 1A flows through the through via 20". A test for measuring the temperature by passing a current through the through via 20 is performed in accordance with JIS C 5012:1993. The current is supplied to the through via 20 until the temperature stabilizes. In the following description, the above condition is also referred to as a current withstand property condition. The through via 20 that satisfies the current withstand property condition is also referred to as "the through via 20 having a current withstand property".

The through via 20 that satisfies the current withstand property condition preferably includes four or more internal portions 26, has the first dimension R1 and the second dimension R2 each of which is 70 µm or more, and has the minimum dimension R3 of 35 µm or more.

As illustrated in Fig. 5, the minimum portion 163 may be located at the midpoint between the first surface 13 and the second surface 14 in the thickness direction of the substrate 12. In Fig. 5, reference sign K3 denotes the distance from the first surface 13 to the minimum portion 163 in the thickness direction of the substrate 12. When the minimum portion 163 is located at the midpoint between the first surface 13 and the second surface 14, a ratio K3/T0 that is the ratio of the distance K3 to the thickness T0 of the substrate is 0.50.

Although not illustrated, the position of the minimum portion 163 in the thickness direction of the substrate 12 may deviate from the midpoint between the first surface 13 and the second surface 14. That is, the ratio K3/T0 may deviate from 0.50. The ratio K3/T0 is, for example, 0.40 or more, and may be 0.45 or more. The ratio K3/T0 is, for example, 0.60 or less, and may be 0.55 or less.

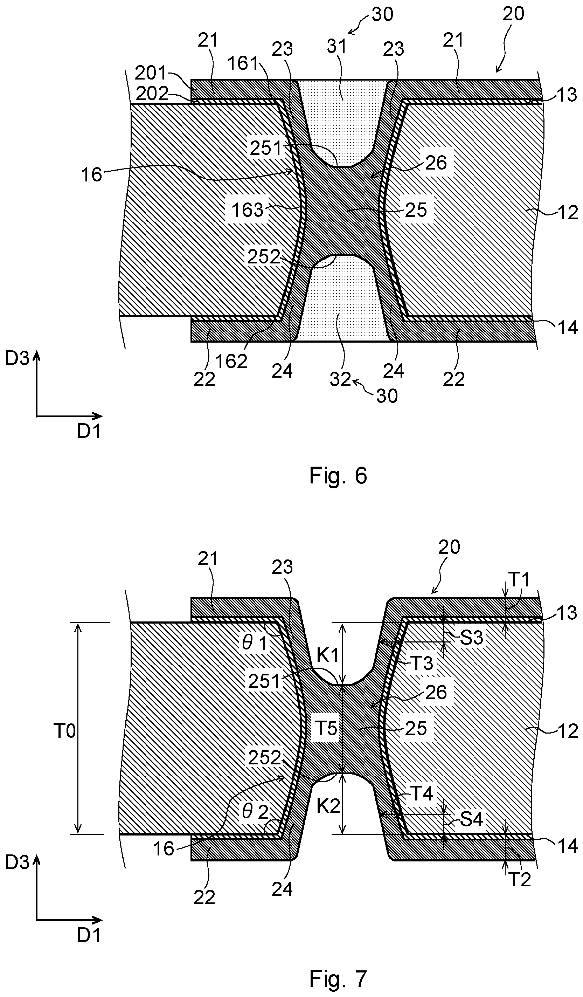

Fig. 6 is a cross-sectional view illustrating an example of the through vias 20. Each of the internal portions 26 of the through via 20 is partially located in the corresponding through hole 15. The term "partially" refers to the case where the entire space of the through hole 15 is not occupied by the corresponding internal portion 26. Each of the internal portions 26 extends along the wall surface 16 of the corresponding through hole 15 from the first surface 13 to the second surface 14.

The through via 20 includes a conductive material. The through via 20 includes at least a plating layer 201. The plating layer 201 is a conductive layer formed by a plating method such as electroplating. The through via 20 may include a seed layer 202. The seed layer 202 is located between the plating layer 201 and the surfaces of the substrate 12, such as the first surface 13, the second surface 14, and the wall surface 16. The seed layer 202 is a layer that has electrical conductivity and is formed by physical vapor deposition, such as sputtering.

A large portion of the through via 20 is constituted by the plating layer 201. The ratio of the thickness of the plating layer 201 to the thickness of the through via 20 located on the wall surface 16 is, for example, 0.80 or more, and may be 0.90 or more.

The plating layer 201 may include a metal such as copper, gold, silver, platinum, rhodium, tin, aluminum, nickel, titanium, chromium, or zinc, or an alloy using the same. The seed layer 202 may contain a metal material such as copper, nickel, titanium, chromium, or zinc. The seed layer 202 may contain a compound of these metal materials.

Each of the internal portions 26 of the through via 20 may include a third portion 23, a fourth portion 24, and the closing portion 25. The closing portion 25 is located on the minimum portion 163 of the wall surface 16 of the through hole 15. The closing portion 25 closes the through hole 15 at the minimum portion 163. The third portion 23 is located on the wall surface 16 between the first portion 21 and the closing portion 25. The third portion 23 is connected to the first portion 21 and the closing portion 25. The fourth portion 24 is located on the wall surface 16 between the second portion 22 and the closing portion 25. The fourth portion 24 is connected to the second portion 22 and the closing portion 25.

The closing portion 25 has a first closing surface 251 and a second closing surface 252. The first closing surface 251 is the surface of the closing portion 25 facing toward the first surface 13. The second closing surface 252 is the surface of the closing portion 25 facing toward the second surface 14.

The third portion 23 and the fourth portion 24 extend along the wall surface 16 of the through hole 15 so as to surround the center of the through hole 15 in plan view.

All of the first portion 21, the second portion 22, the third portion 23, the fourth portion 24, and the closing portion 25 of the through via 20 may include the plating layer 201 and the seed layer 202 described above.

### (Internal Resin)

The internal resins 30 are partially located in their respective through holes 15. The internal resins 30 are made of a resin material filled in the spaces of the through holes 15 where the through vias 20 do not exist. The internal resins 30 include first internal resins 31 located inside the third portions 23 of the through vias 20 and second internal resins 32 located inside the fourth portions 24 of the through vias 20. The term "inside" refers to a direction toward the center point C2 of the through hole 15 in plan view. The term "outward", which will be mentioned later, refers to a direction away from the center point C2 of the through hole 15 in plan view.

Each of the internal resins 30 contains a resin material having insulating properties. The resin material is, for example, an organic material such as polyimide, epoxy, acrylic, or polyphenyl ether.

The dimensions of components of the through vias 20 will be described with reference to Fig. 7. Fig. 7 is a cross-sectional view illustrating an example of the dimensions of the through vias 20. In Fig. 7, the internal resins 30 are omitted.

In Fig. 7, reference sign K1 denotes the maximum value of the distance from the first surface 13 to the first closing surface 251 of the closing portion 25 in the thickness direction of the substrate 12. The distance K1 is also referred to as a first distance. Reference sign K2 denotes the maximum value of the distance from the second surface 14 to the second closing surface 252 of the closing portion 25 in the thickness direction of the substrate 12. The distance K2 is also referred to as a second distance. Reference sign T5 denotes the thickness of the closing portion 25. The thickness T5 is calculated by subtracting the first distance K1 and the second distance K2 from the thickness T0 of the substrate 12. That is, T5 = T0 - (K1 + K2).

The greater the thickness T5 of the closing portion 25, the higher the allowable current of the through via 20 becomes. However, the greater the thickness T5 of the closing portion 25, the more likely defects such as voids are to occur in the plating layer 201. In consideration of these points, it is preferable that the first distance K1 and the second distance K2 are large to some extent.

A ratio K1/T0 that is the ratio of the first distance K1 to the thickness T0 of the substrate 12 is, for example, 0.10 or more, and may be 0.15 or more, or may be 0.20 or more. The ratio K1/T0 is, for example, 0.40 or less, and may be 0.35 or less, or may be 0.30 or less.

A ratio K2/T0 that is the ratio of the second distance K2 to the thickness T0 of the substrate 12 is, for example, 0.10 or more, and may be 0.15 or more, or may be 0.20 or more. The ratio K2/T0 is, for example, 0.40 or less, and may be 0.35 or less, or may be 0.30 or less. The ratio K2/T0 may be the same as the ratio K1/T0 or different from the ratio K1/T0.

A ratio T5/T0 that is the ratio of the thickness T5 of the closing portion 25 to the thickness T0 of the substrate 12 is, for example, 0.20 or more, and may be 0.25 or more. The ratio T5/T0 is, for example, 0.40 or less and may be 0.35 or less.

In Fig. 7, reference sign θ1 denotes the angle between the first surface 13 and the wall surface 16 at the first end 161. The angle θ1 may be larger than 90°. Since the through hole 15 includes the minimum portion 163, the angle θ1 can be larger than 90°. The angle θ1 is, for example, 95° or more, may be 100° or more, and may be 105° or more. The angle θ1 is, for example, 150° or less, and may be 135° or less, or may be 120° or less.

In Fig. 7, reference sign θ2 denotes the angle between the second surface 14 and the wall surface 16 at the second end 162. Similar to the angle θ1, the angle θ2 may be greater than 90°. As the numerical range of the angle θ2, the numerical range relating to the angle θ1 described above may be employed.

When the coefficient of thermal expansion of the through via 20 is different from the coefficient of thermal expansion of the substrate 12, a change in the temperature of the through via 20 causes the through via 20 to expand or contract relative to the substrate 12. The expansion or contraction causes stress between the substrate 12 and the through via 20. Stress caused by temperature change is also referred to as thermal stress. When the internal portion 26 of the through via 20 expands or contracts, a large thermal stress is considered to be generated at the first end 161 and the second end 162 of the through hole 15.

In the present embodiment, since each of the through holes 15 includes the minimum portion 163, the angle θ1 and the angle θ2 can be larger than 90°. When the angle θ1 and the angle θ2 are larger than 90°, the thermal stress at the first end 161 and the second end 162 can be reduced.

In Fig. 7, reference sign T3 denotes the thickness of the third portion 23 of the through via 20. The thickness T3 of the third portion 23 is specified at a position spaced from the first surface 13 by a distance S3 in the thickness direction of the substrate 12. The distance S3 is 50 µm. Reference sign T4 denotes the thickness of the fourth portion 24 of the through via 20. The thickness T4 of the fourth portion 24 is specified at a position spaced from the second surface 14 by a distance S4 in the thickness direction of the substrate 12. The distance S4 is 50 µm. Both the thickness T3 and the thickness T4 are dimensions of the through via 20 in the planar direction of the first surface 13.

As the thicknesses T3 and T4 become larger, the allowable current of the through via 20 becomes higher. However, as the thicknesses T3 and T4 become larger, the uniformity of the thicknesses of the third portion 23 and the fourth portion 24 becomes lower.

Each of the thicknesses T3 and T4 is, for example, 20 µm or more, may be 25 µm or more, and may be 30 µm or more. Each of the thicknesses T3 and T4 is, for example, 50 µm or less, may be 40 µm or less, and may be 35 µm or less.

By appropriately setting the upper limits of the thicknesses T3 and T4, the uniformity of the thickness of each of the third portion 23 and the fourth portion 24 can be ensured.

The uniformity of the thickness of the third portion 23 is evaluated by measuring the thickness of the third portion 23 at a plurality of positions in the thickness direction of the substrate 12. For example, when the difference between the maximum value and the minimum value of the thickness T3, a thickness T31, and a thickness T32 of the third portion 23 is 0.10 µm or less, it is determined that the variation in the thickness of the third portion 23 is 0.10 µm or less. The thickness T3 is the thickness of the third portion 23 measured at a position spaced from the first surface 13 by the distance S3 in the thickness direction of the substrate 12. The thickness T31 is the thickness of the third portion 23 measured at a position spaced from the first surface 13 by (S3 + 20 µm) in the thickness direction of the substrate 12. The thickness T32 is the thickness of the third portion 23 measured at a position spaced from the first surface 13 by (S3 - 20 µm) in the thickness direction of the substrate 12.

As in the case of the third portion 23, the uniformity of the thickness of the fourth portion 24 is also evaluated by measuring the thickness of the fourth portion 24 at a plurality of positions in the thickness direction of the substrate 12. For example, when the difference between the maximum value and the minimum value of the thickness T4, a thickness T41, and a thickness T42 of the fourth portion 24 is 0.10 µm or less, it is determined that the variation in the thickness of the fourth portion 24 is 0.10 µm or less. The thickness T4 is the thickness of the fourth portion 24 measured at a position spaced from the second surface 14 by the distance S4 in the thickness direction of the substrate 12. The thickness T41 is the thickness of the fourth portion 24 measured at a position spaced from the second surface 14 by (S4 + 20 µm) in the thickness direction of the substrate 12. The thickness T42 is the thickness of the fourth portion 24 measured at a position spaced from the second surface 14 by (S4 - 20 µm) in the thickness direction of the substrate 12.

A ratio R3/T3 that is the ratio of the minimum dimension R3 to the thickness T3 of the third portion 23 is, for example, 1.2 or more, and may be 1.5 or more, or may be 1.8 or more. Since the ratio R3/T3 is 1.2 or more, the reliability of the through via 20 can be enhanced. The ratio R3/T3 is, for example, 3.0 or less, and may be 2.4 or less, or may be 2.2 or less. Since the ratio R3/T3 is 3.0 or less, the allowable current of the through via 20 is sufficiently increased.

Similar to the ratio R3/T3, a ratio R3/T4 that is the ratio of the minimum dimension R3 to the thickness T4 of the fourth portion 24 is, for example, 1.2 or more, and may be 1.5 or more, or may be 1.8 or more. Similar to the ratio R3/T3, the ratio R3/T4 is, for example, 3.0 or less, and may be 2.4 or less, or may be 2.2 or less.

The first portion 21 located on the first surface 13 has a thickness T1. The thickness T1 of the first portion 21 may be the same as the thickness T3 of the third portion 23. The thickness T1 of the first portion 21 may be larger or smaller than the thickness T3 of the third portion 23.

The second portion 22 located on the second surface 14 has a thickness T2. The thickness T2 of the second portion 22 may be the same as the thickness T4 of the fourth portion 24. The thickness T2 of the second portion 22 may be larger or smaller than the thickness T4 of the fourth portion 24.

The above-described distances and dimensions of the substrate 12 and the through vias 20 are calculated based on an image of a plane or a cross section of the through-via substrate 10 obtained by using an electron microscope.

### (Method of Manufacturing Through-Via Substrate)

An example of a method of manufacturing the through-via substrate 10 will be described.

### (Through-Hole Forming Step)

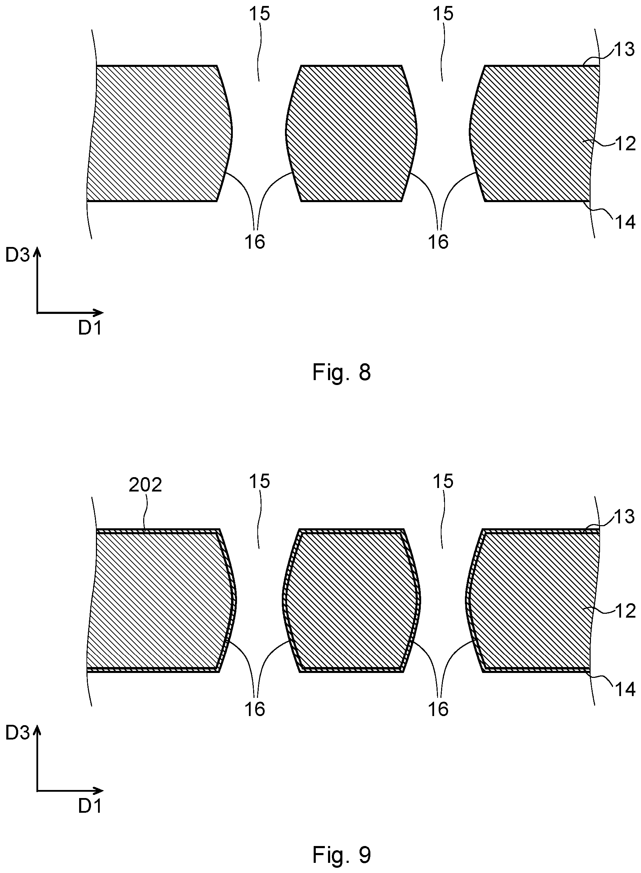

The substrate 12 is prepared. Next, a resist layer is provided on at least one of the first surface 13 and the second surface 14. After that, openings are provided in the resist layer at positions corresponding to the through holes 15. Next, the substrate 12 is processed through the openings of the resist layer. As a result, as illustrated in Fig. 8, the through holes 15 are formed in the substrate 12. Each of the through holes 15 includes the wall surface 16 extending from the first surface 13 to the second surface 14. As a method of processing the substrate 12, a dry etching method, a wet etching method, or the like can be used. The dry etching method is a reactive ion etching method, a deep reactive ion etching method, or the like.

The through holes 15 may be formed in the substrate 12 by irradiating the substrate 12 with a laser beam. In this case, it is not necessary to provide the resist layer. As the laser, an excimer laser, an Nd:YAG laser, a femtosecond laser, or the like can be used. In the case where an Nd:YAG laser is used, a fundamental wave with a wavelength of 1064 nm, a second harmonic wave with a wavelength of 532 nm, a third harmonic wave with a wavelength of 355 nm, or the like can be used.

The step of forming the through holes 15 in the substrate 12 may include a step of irradiating the first surface 13 and the second surface 14 of the substrate 12 with a laser beam, and a wet etching step. In this case, the laser beam is used not for processing the substrate 12 but for partially forming a modified layer on the first surface 13 and the second surface 14 of the substrate 12. In the wet etching step, the modified layer is etched preferentially compared to other portions. By the wet etching, recesses are formed in the modified layer of the first surface 13, and recesses are formed in the modified layer of the second surface 14. The through holes 15 each having the wall surface extending from the first surface 13 to the second surface 14 are formed by connecting the recesses on the first surface 13 to their respective recesses on the second surface 14.

### (Through-Via Forming Step)

Subsequently, a through-via forming step of forming the through vias 20 into the through holes 15 is performed. The through-via forming step includes a seed-layer forming step and a plating-layer forming step.

In the seed-layer forming step, as illustrated in Fig. 9, the seed layer 202 is formed on the first surface 13, the second surface 14, and the wall surfaces 16 of the substrate 12. For example, the seed layer 202 is formed by sputtering.

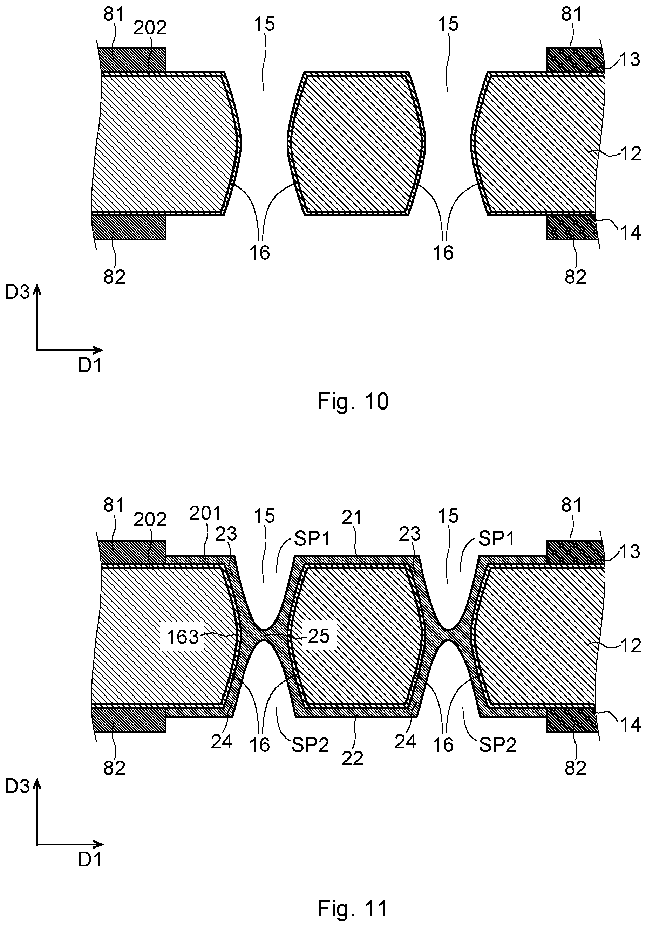

The plating-layer forming step includes a resist-layer forming step, a plating step, and a resist-layer removing step. Fig. 10 is a cross-sectional view illustrating an example of the resist-layer forming step. In the resist-layer forming step, a first resist layer 81 is formed on a portion of the seed layer 202 located on the first surface 13, and a second resist layer 82 is formed on a portion of the seed layer 202 located on the second surface 14. The first resist layer 81 and the second resist layer 82 are provided to cover a region of the seed layer 202 where the plating layer 201 is not to be formed.

Fig. 11 is a cross-sectional view illustrating an example of the plating step. In the plating step, the plating layer 201 is formed on the seed layer 202 by electrolytic plating. For example, the substrate 12 on which the seed layer 202 and the resist layers 81, 82 have been formed may be immersed in an electrolytic plating solution. The plating layer 201 is deposited on the seed layer 202 by applying a current to the seed layer 202.

Each of the through holes 15 of the substrate 12 includes the minimum portion 163. When the growth of the plating layer 201 progresses, portions of the plating layer 201 formed along the circumferential direction of the through hole 15 are connected to each other at the minimum portion 163. That is, as illustrated in Fig. 11, the through hole 15 is closed by the plating layer 201 at the minimum portion 163. That is, the closing portion 25 is formed. In the subsequent plating step, the electrolytic plating solution is circulated in a first space SP1 and a second space SP2. The first space SP1 is a space located between the minimum portion 163 and the first surface 13 in the thickness direction of the substrate 12. The second space SP2 is a space located between the minimum portion 163 and the second surface 14 in the thickness direction of the substrate 12.

The plating step before the through hole 15 is closed by the plating layer 201 at the minimum portion 163 is also referred to as a first plating step. The plating step after the through hole 15 has been closed by the plating layer 201 at the minimum portion 163 is also referred to as a second plating step.

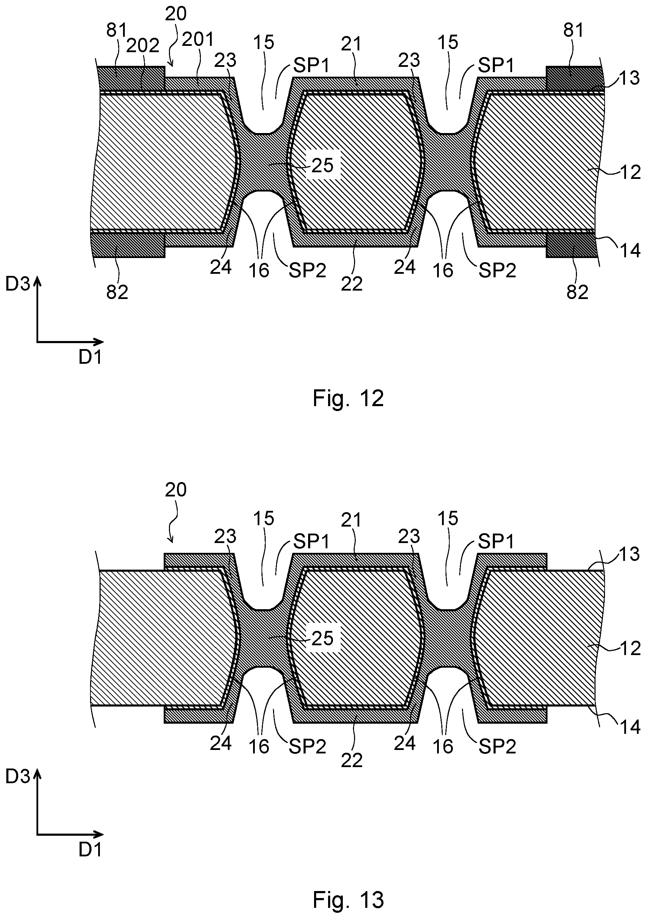

In the second plating step, the growth of the plating layer 201 progresses in the first space SP1 and the second space SP2. For example, as illustrated in Fig. 12, the closing portion 25 grows in the thickness direction of the substrate 12. The duration of the second plating step is adjusted such that the numerical ranges relating to the first distance K1, the second distance K2, the thickness T5 of the closing portion 25, and the like described above are achieved. For example, the second plating step is performed such that the ratio of the thickness T5 of the closing portion 25 to the thickness T0 of the substrate 12 is 0.20 or more and 0.40 or less.

Subsequently, as illustrated in Fig. 13, the resist-layer removing step of removing the first resist layer 81 and the second resist layer 82 is performed. Subsequently, a seed-layer removing step of removing a portion of the seed layer 202 is performed. In the seed-layer removing step, as illustrated in Fig. 13, the seed layer 202 overlapping the first resist layer 81 and the second resist layer 82 in plan view is removed. In this way, the through vias 20 are obtained.

### (Resin-Layer Forming Step)

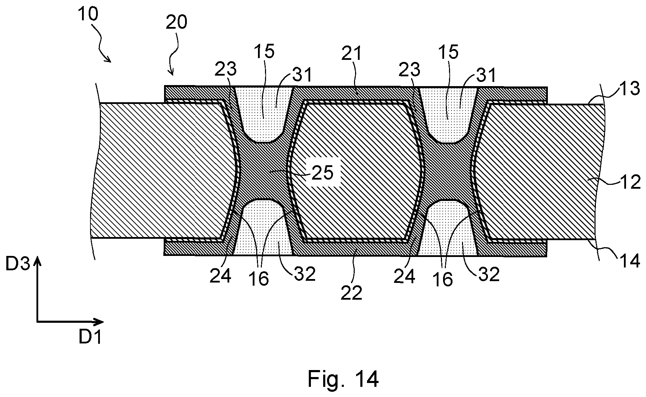

Subsequently, the resin-layer forming step of forming the internal resins 30 is performed. For example, a layer containing a resin material is formed on the first surface 13 and the second surface 14. For example, a resin film including a layer containing a resin material is attached to the first surface 13 and the second surface 14. Subsequently, the layer containing the resin material located on the first surface 13 is pushed into the space inside the third portion 23. In addition, the layer containing the resin material located on the second surface 14 is pushed into the space inside the fourth portion 24. Subsequently, the resin material is cured. For example, the layer containing the resin material is irradiated with ultraviolet light. As a result, as illustrated in Fig. 14, the first internal resins 31 and the second internal resins 32 are formed. In this way, the through-via substrate 10 including the substrate 12, the through vias 20, and the internal resins 30 is obtained.

Each of the plurality of through vias 20 of the through-via substrate 10 of the present embodiment includes the plurality of internal portions 26 located inside the respective plurality of through holes 15. That is, a multi-via structure is employed in the present embodiment. The through vias 20 of the present embodiment can increase the allowable current of the through vias 20 while suppressing the occurrence of defects such as voids compared with a through via of the related art.

A through via of the related art includes only one internal portion 26 located inside one through hole 15. A structure in which one through via 20 includes only one internal portion 26 located inside one through hole 15 is also referred to as a single via structure. As means for increasing the allowable current of the through via 20 having a single via structure, two means are considered. The first means is to increase the first dimension R1 and the second dimension R2 of the through holes 15. The second means is to increase the thickness of the plating layer 201.

In the first means, in order to satisfy the above-described current withstand property condition, for example, it is preferable that each of the first dimension R1 and the second dimension R2 be 180 µm or more and that the minimum dimension R3 be 60 µm or more. However, as the first dimension R1 and the second dimension R2 become larger, the spaces of the through holes 15 where the plating layer does not exist become larger. As a result, there is a concern that defects such as voids may occur in the resin material. In the second means, as the thickness of the plating layer increases, defects such as voids are likely to occur in the plating layer. In addition, variations in the thickness of the plating layer depending on the position are also likely to occur.

In the present embodiment, a multi-via structure is employed. In the multi-via structure, the allowable current of the through via 20 can be increased by increasing the number of the through holes 15 overlapping one first portion 21 in plan view. Therefore, according to the present embodiment, even when the dimensions of the through holes 15 are small and the thickness of the plating layer 201 is small, a sufficient allowable current of the through via 20 can be achieved. For example, even when each of the first dimension R1 and the second dimension R2 is less than 180 µm and the minimum dimension R3 is less than 60 µm, the above-described current withstand property condition can be satisfied. Therefore, each of the through vias 20 of the present embodiment can increase the allowable current of the through via 20 while suppressing the occurrence of defects such as voids compared with a through via of the related art.

Preferably, each of the through vias 20 includes the first portion 21, the second portion 22, the third portions 23, the fourth portions 24, and the closing portions 25, and the internal resins 30 include the first internal resins 31 and the second internal resins 32. In other words, each of the internal resins 30 is divided into the first internal resin 31 and the second internal resin 32 by the closing portion 25 in the third direction D3. With this configuration, since the volumes of the first internal resins 31 and the second internal resins 32 are limited, the occurrence of defects such as voids in the resin material can be suppressed.

The above-described embodiment can be modified in various ways. Modifications will be described with reference to the drawings as necessary. In the following description and the drawings used in the following description, the same reference signs as those used for the corresponding portions in the above-described embodiment are used for portions that can be configured in a manner similar to those of the above-described embodiment. The overlapping description will be omitted. In addition, in a case where it is apparent that the operational effects obtained in the above-described embodiment can also be obtained in the modifications, the description thereof may sometimes be omitted.

### (First Modification)

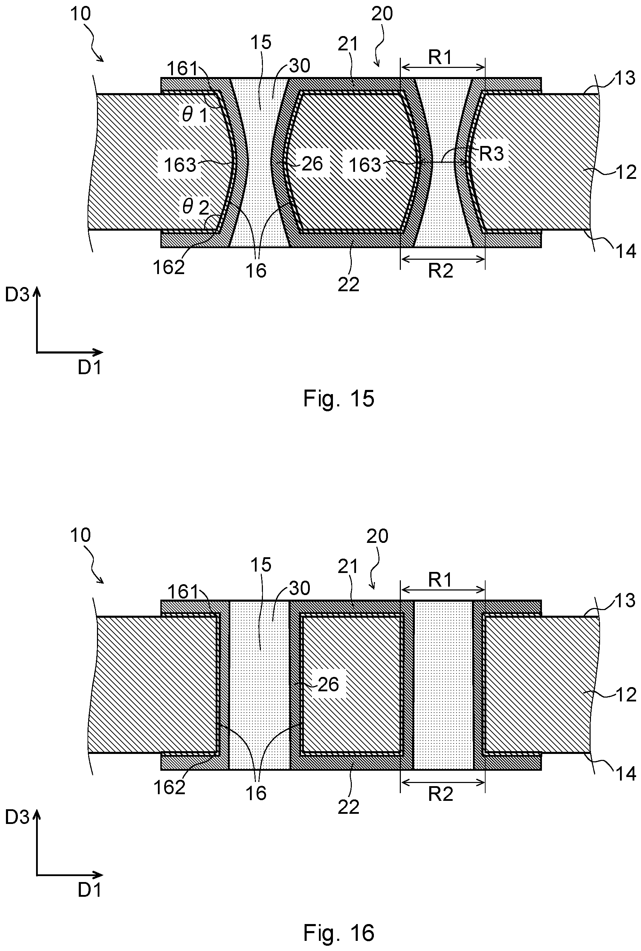

Fig. 15 is a cross-sectional view illustrating the through-via substrate 10 according to the first modification. It is not necessary for the internal portions 26 of the through vias 20 of the through-via substrate 10 to include the closing portions 25. For example, each of the internal portions 26 may be located on the wall surface 16 such that it extends from the first end 161 to the second end 162. The through vias 20 including such internal portions 26 are also referred to as conformal vias. The numerical ranges relating to the thicknesses T3 and T4 described above may be employed as the numerical ranges of the thicknesses of the internal portions 26.

As illustrated in Fig. 15, the through-via substrate 10 may include a plurality of internal resins 30 each of which is located inside the internal portion 26 of a corresponding one of the plurality of through holes 15. Each of the plurality of internal resins 30 may continuously spread from the first surface 13 to the second surface 14 inside the through hole 15.

As illustrated in Fig. 15, each of the through holes 15 of the through-via substrate 10 may include the minimum portion 163 located between the first end 161 and the second end 162. Since the through holes 15 include the minimum portions 163, the volumes of the internal resins 30 can be reduced. By reducing the volumes of the internal resins 30, the occurrence of defects such as voids in the resin material can be suppressed. As the numerical ranges of the dimensions of the through holes 15, the numerical ranges relating to the first dimension R1, the second dimension R2, and the minimum dimension R3, which have been described above, may be employed.

Also in the first modification, each of the plurality of through vias 20 includes the plurality of internal portions 26 located inside the plurality of through holes 15. That is, a multi-via structure is employed also in the first modification. The first modification can also increase the allowable current of the through vias 20 while suppressing the occurrence of defects such as voids.

### (Second Modification)

Fig. 16 is a cross-sectional view illustrating the through-via substrate 10 according to the second modification. The through holes 15 of the through-via substrate 10 illustrated in Fig. 16 are different from the through holes 15 of the through-via substrate 10 illustrated in Fig. 15 in that each of the through holes 15 does not include the minimum portion 163. For example, the through holes 15 of the through-via substrate 10 illustrated in Fig. 16 may each have a constant dimension regardless of the position in the third direction D3.

In order for a conformal via having a single via structure formed by the through hole 15 not including the minimum portion 163 to satisfy the above-described current withstand property condition, for example, it is preferable that each of the first dimension R1 and the second dimension R2 be 104 µm or more and that the thickness of the internal portion 26 be 30 µm or more.

Also in the second modification, each of the plurality of through vias 20 includes the plurality of internal portions 26 located inside the plurality of through holes 15. That is, a multi-via structure is employed also in the second modification. According to the second modification, even when the dimensions of the through holes 15 are small, the allowable current of the through vias 20 can be increased while suppressing the occurrence of defects such as voids. For example, even when each of the first dimension R1 and the second dimension R2 is less than 104 µm, the above-described current withstand property condition can be satisfied.

### (Third Modification)

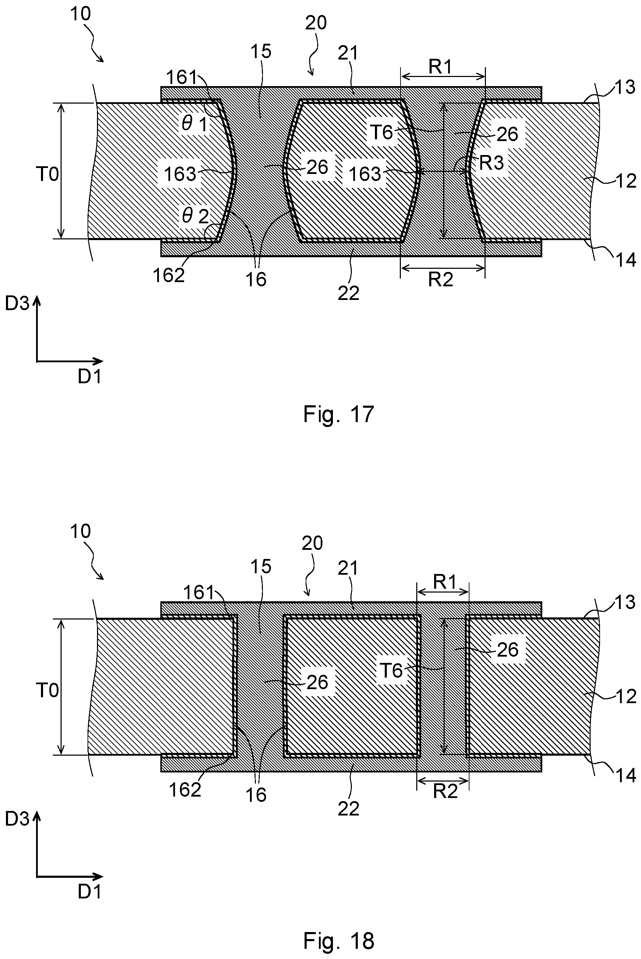

Fig. 17 is a cross-sectional view illustrating the through-via substrate 10 according to the third modification. As illustrated in Fig. 17, the entire space of each of the through holes 15 may be occupied by the corresponding internal portion 26. The through vias 20 including such internal portions 26 are also referred to as filled vias.

Reference sign T6 denotes the thickness of each of the internal portions 26. As illustrated in Fig. 17, when the entire space of each of the through holes 15 is occupied by the corresponding internal portion 26, the thickness T6 of each of the internal portions 26 is equal to the thickness T0 of the substrate 12.

As illustrated in Fig. 17, each of the through holes 15 of the through-via substrate 10 may include the minimum portion 163 located between the first end 161 and the second end 162. Since the through holes 15 include the minimum portions 163, the volumes of the internal portions 26 can be reduced. By reducing the volumes of the internal portions 26, the occurrence of defects such as voids in the conductive material can be suppressed. As the numerical ranges of the dimensions of the through holes 15, the numerical ranges relating to the first dimension R1, the second dimension R2, and the minimum dimension R3, which have been described above may be employed.

Also in the third modification, each of the plurality of through vias 20 includes the plurality of internal portions 26 located inside the plurality of through holes 15. That is, a multi-via structure is employed also in the third modification. The third modification can also increase the allowable current of the through vias 20 while suppressing the occurrence of defects such as voids.

### (Fourth Modification)

Fig. 18 is a cross-sectional view illustrating the through-via substrate 10 according to the fourth modification. The through holes 15 of the through-via substrate 10 illustrated in Fig. 18 are different from the through holes 15 of the through-via substrate 10 illustrated in Fig. 17 in that each of the through holes 15 does not include the minimum portion 163. For example, the through holes 15 of the through-via substrate 10 illustrated in Fig. 18 may each have a constant dimension regardless of the position in the third direction D3.

In order for a filled via having a single via structure formed by the through hole 15 not including the minimum portion 163 to satisfy the above-described current withstand property condition, for example, it is preferable that each of the first dimension R1 and the second dimension R2 be 94 µm or more.

Also in the fourth modification, each of the plurality of through vias 20 includes the plurality of internal portions 26 located inside the plurality of through holes 15. That is, a multi-via structure is employed also in the fourth modification. According to the fourth modification, even when the dimensions of the through holes 15 are small, the allowable current of the through vias 20 can be increased while suppressing the occurrence of defects such as voids. For example, even when each of the first dimension R1 and the second dimension R2 is less than 94 µm, the above-described current withstand property condition can be satisfied.

### (Fifth Modification)

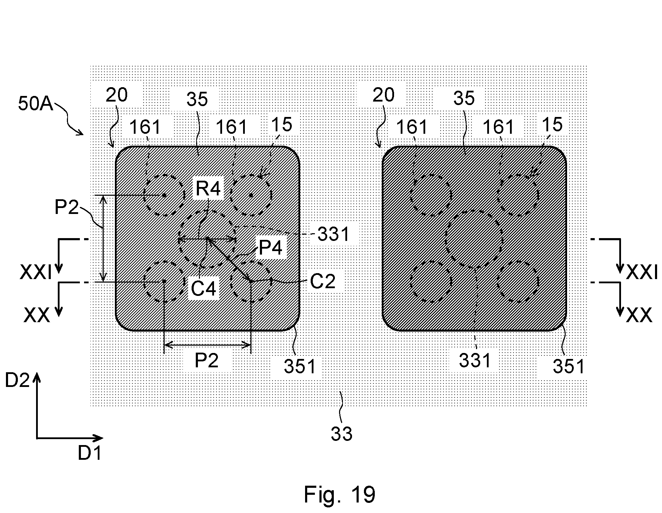

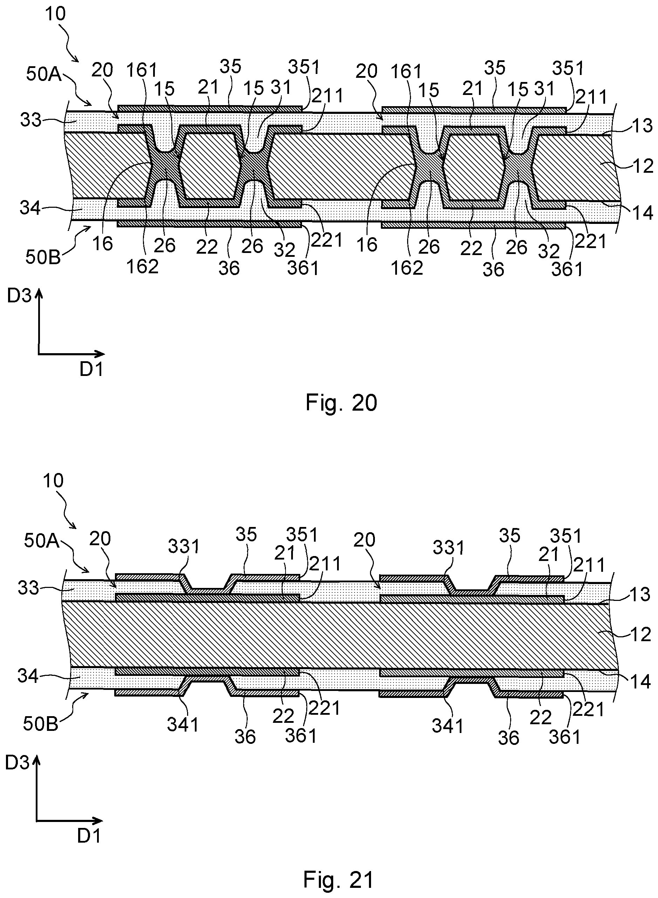

Fig. 19 is a plan view illustrating the through-via substrate 10 according to the fifth modification. Fig. 20 is a cross-sectional view of the through-via substrate 10 taken along line XX-XX of Fig. 19. Fig. 21 is a cross-sectional view of the through-via substrate 10 taken along line XXI-XXI of Fig. 19.

The through-via substrate 10 may include a first wiring layer 50A and a second wiring layer 50B. The first wiring layer 50A is located on the first surface 13 of the substrate 12. The second wiring layer 50B is located on the second surface 14 of the substrate 12. The first wiring layer 50A includes at least one insulating layer and at least one conductive layer. The second wiring layer 50B includes at least one insulating layer and at least one conductive layer.

The first wiring layer 50A of the through-via substrate 10 may include a plurality of first conductive layers 35 and a first resin layer 33. Each of the plurality of first conductive layers 35 is connected to the first portion 21 of the corresponding through via 20. In other words, each of the first portions 21 of the plurality of through vias 20 is connected to the corresponding first conductive layer 35. The first resin layer 33 is located between the plurality of first portions 21 and the plurality of first conductive layers 35 in the third direction D3.

The first conductive layers 35 include a conductive material. The conductive material may include a metal such as copper, gold, silver, platinum, rhodium, tin, aluminum, nickel, titanium, chromium, or zinc, or an alloy using the same.

As illustrated in Fig. 19, each of the plurality of first conductive layers 35 may have an outline 351 surrounding the corresponding plurality of through holes 15 in plan view. The outline 351 of each of the first conductive layers 35 may extend along the outline 211 of the corresponding first portion 21 in plan view.

The first resin layer 33 contains a resin material having insulating properties. The resin material is, for example, an organic material such as polyimide, epoxy, acrylic, or polyphenyl ether.

As illustrated in Figs. 19 and 21, the first resin layer 33 may have a plurality of openings 331. Each of the plurality of openings 331 of the first resin layer 33 overlaps the corresponding first portion 21 in plan view. Each of the openings 331 may be formed in a portion of the first resin layer 33, the portion overlapping a corresponding one of the first portions 21 in plan view. A portion of each of the first conductive layers 35 may be located in the corresponding opening 331. For example, each of the first conductive layers 35 may be connected to the first portion 21 of the corresponding through via 20 in the corresponding opening 331 of the first resin layer 33.

Each of the openings 331 of the first resin layer 33 has a fourth dimension R4 in plan view. Each of the openings 331 may have a circular outline in plan view. In this case, the fourth dimension R4 refers to the diameter of the opening 331. Each of the openings 331 may have an outline other than a circular shape in plan view. When an outline other than a circular shape is employed, the fourth dimension R4 may be an equivalent circle diameter. For example, the fourth dimension R4 may be the diameter of a circle having an area equal to the area of each of the openings 331 in plan view.

The fourth dimension R4 of each of the openings 331 may be larger than the first dimension R1 of each of the through holes 15. A ratio R4/R1 that is the ratio of the fourth dimension R4 to the first dimension R1 is, for example, 1.2 or more, and may be 1.5 or more, or may be 2.0 or more. The larger the ratio R4/R1 is, the more the contact resistance between the first portion 21 of the through via 20 and the first conductive layer 35 can be reduced. The ratio R4/R1 is, for example, 5.0 or less, and may be 4.0 or less, or 3.0 or less.

In Fig. 19, reference sign P4 denotes the shortest distance between the center point C4 of each of the openings 331 and the center point C2 of the corresponding through hole 15 in plan view. The shortest distance P4 may be smaller than the second pitch P2. A ratio P4/P2 that is the ratio of the shortest distance P4 to the second pitch P2 is, for example, 0.9 or less, and may be 0.8 or less, or may be 0.7 or less.

As illustrated in Figs. 20 and 21, the first resin layer 33 may include a portion in contact with the first surface 13. The first resin layer 33 may include a portion in contact with the first portions 21.

As illustrated in Fig. 21, the first resin layer 33 may be integrated with the first internal resins 31 of the internal resins 30. For example, the first resin layer 33 and the first internal resins 31 may be formed of the same resin film in the resin-layer forming step.

As illustrated in Figs. 19 to 21, the second wiring layer 50B of the through-via substrate 10 may include a plurality of second conductive layers 36 and a second resin layer 34. Each of the plurality of second conductive layers 36 is connected to the second portion 22 of the corresponding through via 20. In other words, each of the second portions 22 of the plurality of through vias 20 is connected to the corresponding second conductive layer 36. The second resin layer 34 is located between the plurality of second portions 22 and the plurality of second conductive layers 36 in the third direction D3.

The second conductive layers 36 include a conductive material. The conductive material may include a metal such as copper, gold, silver, platinum, rhodium, tin, aluminum, nickel, titanium, chromium, or zinc, or an alloy using the same.

Each of the plurality of second conductive layers 36 may have an outline 361 surrounding the corresponding plurality of through holes 15 in plan view. The outline 361 of each of the second conductive layers 36 may extend along the outline 221 of the corresponding second portion 22 in plan view.

The second resin layer 34 contains a resin material having insulating properties. The resin material is, for example, an organic material such as polyimide, epoxy, acrylic, or polyphenyl ether.

The second resin layer 34 may have a plurality of openings 341. Each of the plurality of openings 341 of the second resin layer 34 overlaps the corresponding second portion 22 in plan view. A portion of each of the second conductive layers 36 may be located in the corresponding opening 341. For example, each of the second conductive layers 36 may be connected to the second portion 22 of the corresponding through via 20 in the corresponding opening 341 of the second resin layer 34.

As illustrated in Figs. 20 and 21, the second resin layer 34 may include a portion in contact with the second surface 14. The second resin layer 34 may include a portion in contact with the second portions 22.

As illustrated in Fig. 21, the second resin layer 34 may be integrated with the second internal resins 32 of the internal resins 30. For example, the second resin layer 34 and the second internal resins 32 may be formed of the same resin film in the resin-layer forming step.

### (Sixth Modification)

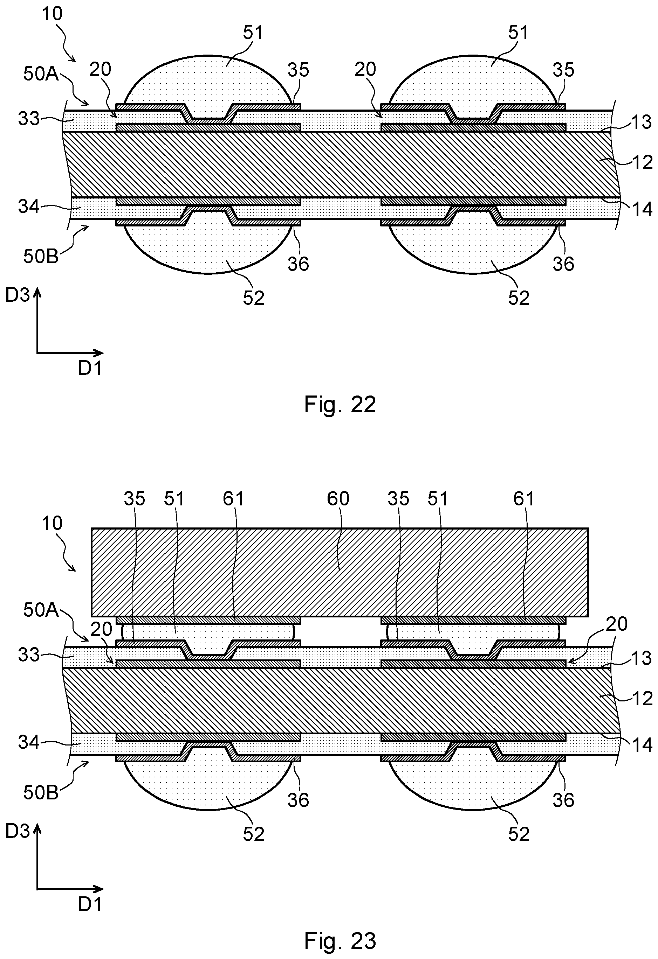

Fig. 22 is a cross-sectional view illustrating the through-via substrate 10 according to the sixth modification. The through-via substrate 10 illustrated in Fig. 22 is different from the through-via substrate 10 illustrated in Fig. 21 in that it includes a plurality of first bumps 51. The through-via substrate 10 may include a plurality of second bumps 52.

Each of the plurality of first bumps 51 may be located on a conductive layer of the first wiring layer 50A. For example, each of the plurality of first bumps 51 may be located on the corresponding first conductive layer 35 connected to the corresponding first portion 21 of the corresponding through via 20. Each of the first bumps 51 may contain solder.

Each of the plurality of second bumps 52 may be located on a conductive layer of the second wiring layer 50B. For example, each of the plurality of second bumps 52 may be located on the corresponding second conductive layer 36 connected to the second portion 22 of the corresponding through via 20. Each of the second bumps 52 may contain solder.

### (Seventh Modification)

Fig. 23 is a cross-sectional view illustrating the through-via substrate 10 according to the seventh modification. The through-via substrate 10 illustrated in Fig. 23 is different from the through-via substrate 10 illustrated in Fig. 22 in that it includes an element 60. The through-via substrate 10 on which the element 60 is mounted is also referred to as a mounting substrate.

The element 60 may be a semiconductor element. The semiconductor element includes a transistor formed of a semiconductor such as silicon. The semiconductor element is, for example, a CPU, a GPU, an FPGA, a sensor, or a memory. The semiconductor element may be a chiplet formed by dividing a semiconductor element such as a CPU, a GPU, an FPGA, a sensor, or a memory for each function.

The element 60 may include a plurality of terminals 61. Each of the plurality of terminals 61 may be connected to a corresponding one of the first bumps 51.

Although not illustrated, the through-via substrate 10 on which the element 60 is mounted may be mounted on a wiring substrate such as a motherboard. For example, each of the plurality of second bumps 52 may be connected to a corresponding one of pads of the wiring substrate.

### (Eighth Modification)

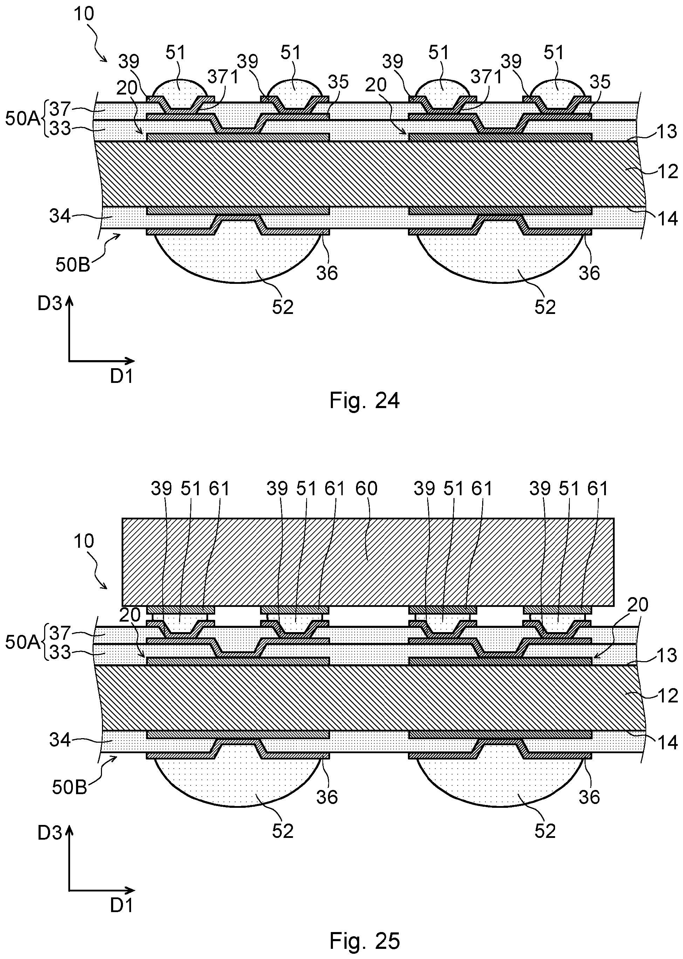

Fig. 24 is a cross-sectional view illustrating the through-via substrate 10 according to the eighth modification. The first wiring layer 50A of the through-via substrate 10 illustrated in Fig. 24 is different from the through-via substrate 10 illustrated in Fig. 21 in that the first wiring layer 50A includes a plurality of third conductive layers 39 and a third resin layer 37.

As illustrated in Fig. 24, the plurality of third conductive layers 39 may be connected to each of the plurality of first conductive layers 35. In other words, each of the first conductive layers 35 may be connected to the corresponding plurality of third conductive layers 39. The third resin layer 37 is located between the first conductive layers 35 and the plurality of third conductive layers 39 in the third direction D3.

The third conductive layers 39 contain a conductive material. The conductive material may include a metal such as copper, gold, silver, platinum, rhodium, tin, aluminum, nickel, titanium, chromium, or zinc, or an alloy using the same.

The third resin layer 37 contains a resin material having insulating properties. The resin material is, for example, an organic material such as polyimide, epoxy, acrylic, or polyphenyl ether.

As illustrated in Fig. 24, the through-via substrate 10 may include the plurality of first bumps 51 located on the plurality of third conductive layers 39.

As illustrated in Fig. 25, the through-via substrate 10 may include the element 60. The element 60 may include the plurality of terminals 61. Each of the plurality of terminals 61 may be connected to the corresponding first bump 51.

The number and arrangement of the third conductive layers 39 connected to each of the first conductive layers 35 are determined according to the number and arrangement of the terminals 61 of the element 60. According to the eighth modification, by connecting each of the first conductive layers 35 to the corresponding plurality of third conductive layers 39, the through-via substrate 10 can accommodate various arrangements of the plurality of terminals 61.

### (Ninth Modification)

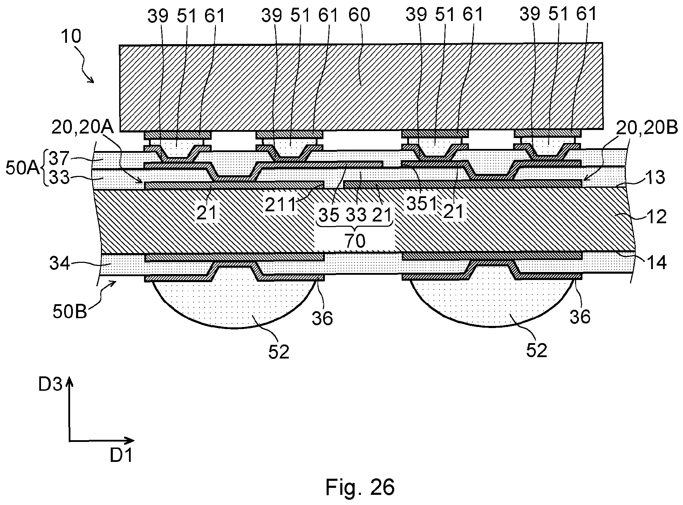

Fig. 26 is a cross-sectional view illustrating the through-via substrate 10 according to the ninth modification. The two adjacent through vias 20 are also referred to as a first through via 20A and a second through via 20B. The first through via 20A may be connected to a power supply potential, and the second through via 20B may be connected to a ground potential.

The first conductive layer 35 connected to the first through via 20A may extend outward beyond the outline 211 of the first portion 21 of the first through via 20A. The first portion 21 of the second through via 20B may extend outward beyond the outline 351 of the first conductive layer 35 connected to the first portion 21 of the second through via 20B. In the third direction D3, a portion of the first conductive layer 35 connected to the first through via 20A and a portion of the first portion 21 of the second through via 20B may face each other. A portion of the first resin layer 33 is located between a portion of the first conductive layer 35 and a portion of the first portion 21 that face each other. A capacitor 70 is constituted by a portion of the first conductive layer 35, a portion of the first portion 21, and a portion of the first resin layer 33.

The capacitance of the capacitor 70 is, for example, 1 pF or more, and may be 10 pF or more. The capacitance of the capacitor 70 is, for example, 1 nF or less, and may be 100 pF or less. The capacitor 70 can increase the stability of the power supply voltage of the element 60.

### (Tenth Modification)

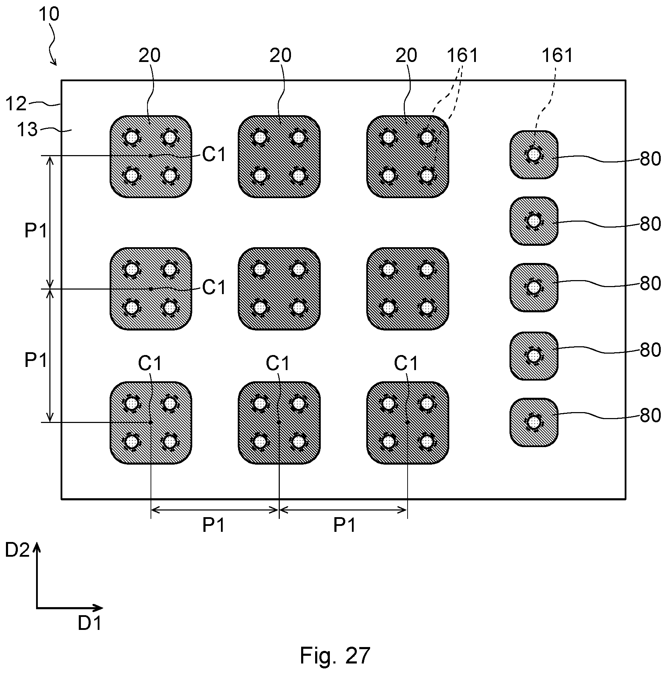

Fig. 27 is a plan view illustrating the through-via substrate 10 according to the tenth modification. The through-via substrate 10 may include, in addition to the plurality of through vias 20 each having a multi-via structure, a plurality of through vias 80 each having a single-via structure. The plurality of through vias 20 may be electrically connected to the power supply potential or the ground potential. Each of the plurality of through vias 80 may be electrically connected to a wiring line or a terminal through which data is transmitted.

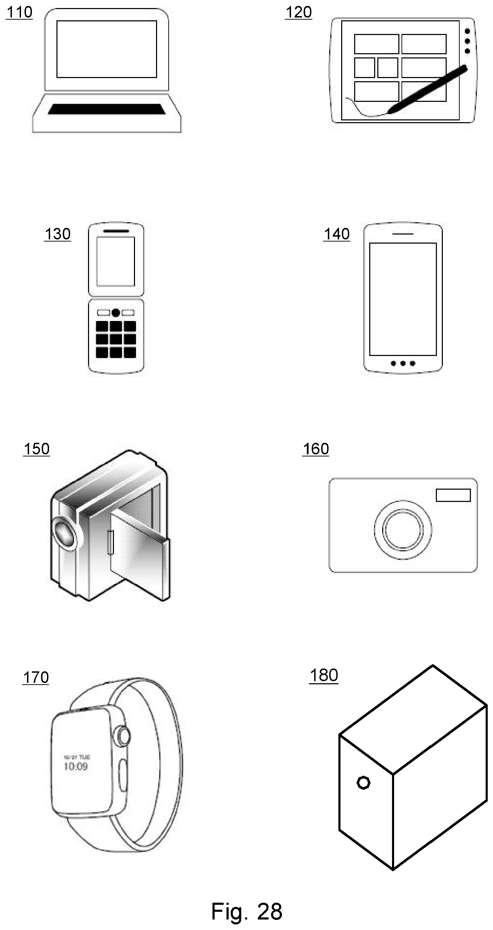

Fig. 28 is a diagram illustrating examples of products on which the through-via substrate 10 is to be mounted. The through-via substrate 10 can be used in various products. For example, it is mounted on a notebook personal computer 110, a tablet terminal 120, a mobile phone 130, a smartphone 140, a digital video camera 150, a digital camera 160, a digital watch 170, a server 180, and the like.

### (Eleventh Modification)

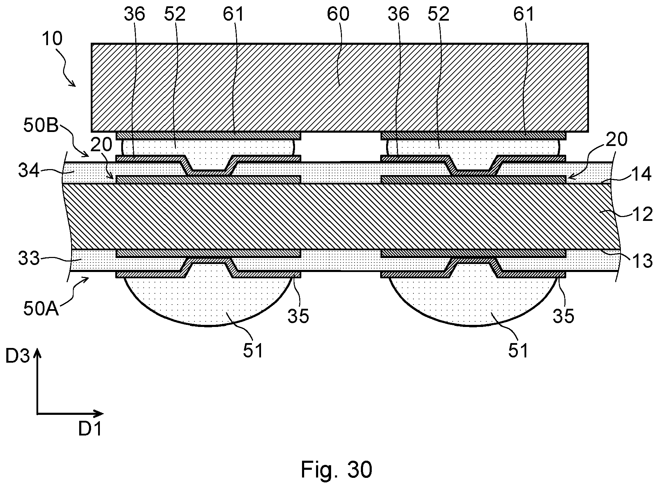

Fig. 30 is a cross-sectional view illustrating the through-via substrate 10 according to the eleventh modification. The case illustrated in Fig. 30 is different from the case illustrated in Fig. 23 in that the plurality of terminals 61 of the element 60 are connected to the second bumps 52.

Although not illustrated, the through-via substrate 10 on which the element 60 is mounted may be mounted on a wiring substrate such as a motherboard. For example, each of the plurality of first bumps 51 may be connected to a corresponding one of pads of the wiring substrate.

### (Twelfth Modification)

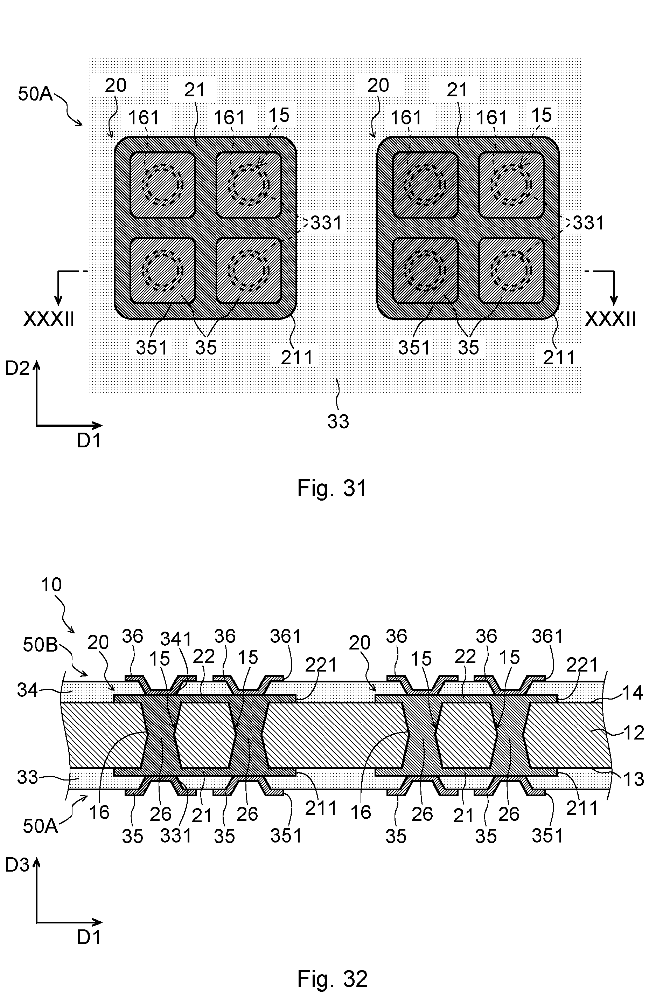

Fig. 31 is a plan view illustrating a portion of the through-via substrate 10 according to the twelfth modification. Fig. 32 is a cross-sectional view of the through-via substrate 10 taken along line XXXII-XXXII of Fig. 31.

The first wiring layer 50A may include the plurality of first conductive layers 35 connected to each of the plurality of first portions 21. That is, each of the first portions 21 may be connected to the corresponding plurality of first conductive layers 35. The plurality of first conductive layers 35 connected to one of the first portions 21 may be separated from each other in an in-plane direction of the first surface 13.

The first resin layer 33 of the first wiring layer 50A may have the plurality of openings 331. Each of the plurality of openings 331 of the first resin layer 33 overlaps the corresponding first portion 21 in plan view. Each of the plurality of openings 331 of the first resin layer 33 may overlap the corresponding through hole 15 and the corresponding internal portion 26 in plan view. Each of the plurality of first conductive layers 35 connected to one of the first portions 21 may be connected to the first portion 21 at the corresponding opening 331.

The second wiring layer 50B may include the plurality of second conductive layers 36 connected to each of the plurality of second portions 22. That is, each of the second portions 22 may be connected to the corresponding plurality of second conductive layers 36. The plurality of second conductive layers 36 connected to one of the second portions 22 may be separated from each other in an in-plane direction of the second surface 14.

The second resin layer 34 of the second wiring layer 50B may have the plurality of openings 341. Each of the plurality of openings 341 of the second resin layer 34 overlaps the corresponding second portion 22 in plan view. Each of the plurality of openings 341 of the second resin layer 34 may overlap the corresponding through hole 15 and the corresponding internal portion 26 in plan view. Each of the plurality of second conductive layers 36 connected to one of the second portions 22 may be connected to the second portion 22 at the corresponding opening 341.

Each of the plurality of internal portions 26 connected to one of the first portions 21 may be a filled via.

Although not illustrated, each of the plurality of internal portions 26 may be a via of a type other than a filled via. When each of the plurality of internal portions 26 is a via of a type other than a filled via, each of the plurality of openings 331 of the first resin layer 33 does not necessarily overlap either the through hole 15 or the internal portion 26 in plan view.

### (Thirteenth Modification)

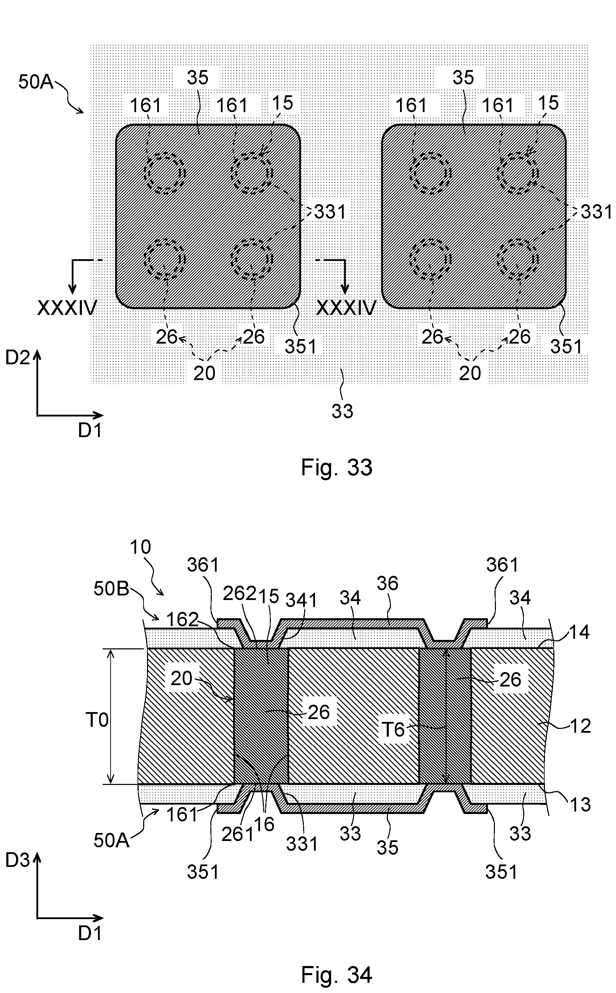

Fig. 33 is a plan view illustrating a portion of the through-via substrate 10 according to the thirteenth modification. Fig. 34 is a cross-sectional view of the through-via substrate 10 taken along line XXXIV-XXXIV of Fig. 33. The through-via substrate 10 includes the substrate 12, the plurality of through vias 20, the first wiring layer 50A, and the second wiring layer 50B.

The through-via substrate 10 in the thirteenth modification is different from the above-described embodiment and modifications in that each of the through vias 20 does not include either the first portion 21 or the second portion 22.

In the through-via substrate 10 according to the thirteenth modification, the internal portions 26 located in the plurality of through holes 15 are each a filled via. Each of the plurality of internal portions 26 has a first end surface 261 and a second end surface 262. The first end surface 261 and the second end surface 262 are end surfaces of the internal portion 26 in the thickness direction of the substrate 12. The first end surface 261 is close to the first surface 13. The second end surface 262 is close to the second surface 14.

Each of the internal portions 26 has the thickness T6 in the thickness direction of the substrate 12. The thickness T6 of each of the internal portions 26 may be approximately equal to the thickness T0 of the substrate 12. A ratio T6/T0 that is the ratio of the thickness T6 of each of the internal portions 26 to the thickness T0 of the substrate 12 is, for example, 0.80 or more, may be 0.85 or more, and may be 0.90 or more. The ratio T6/T0 is, for example, 1.20 or less, and may be 1.15 or less, or may be 1.10 or less. The thickness T6 is measured along a virtual straight line that passes through the center point of the through hole 15 in plan view and extends in the thickness direction. The internal portion 26 that satisfies the above numerical range relating to the ratio T6/T0 is referred to as a filled via.

Also in the present modification, each of the through vias 20 is constituted by electrically connecting the corresponding plurality of internal portions 26 to each other, as in the case of the above-described embodiment and modifications. That is, a multi-via structure is employed also in the present modification. Therefore, even when the dimensions of the through holes 15 are small, a sufficient allowable current of the through vias 20 can be achieved. Since the dimensions of the through holes 15 are small, the occurrence of defects such as voids in the internal portions 26 is suppressed.

In the present modification example, the plurality of internal portions 26 are electrically connected to each other by at least one conductive layer included in the first wiring layer 50A. The first wiring layer 50A will be described.

As illustrated in Fig. 33, the first wiring layer 50A may include the first resin layer 33 and the plurality of first conductive layers 35. As illustrated in Fig. 34, the first resin layer 33 is located on the first surface 13. The first resin layer 33 may be in contact with the first surface 13.

The first resin layer 33 has the plurality of openings 331 extending through the first resin layer 33. As illustrated in Figs. 33 and 34, each of the plurality of openings 331 of the first resin layer 33 may overlap the corresponding through hole 15 and the corresponding internal portion 26 in plan view. In the case illustrated in Figs. 33 and 34, each of the four openings 331 overlaps a corresponding one of the four internal portions 26.

The first resin layer 33 may overlap the boundaries between the wall surfaces 16 of the through holes 15 and the internal portions 26 in plan view. For example, the first resin layer 33 may overlap the first ends 161 of the wall surfaces 16 in plan view. The first ends 161 define the boundaries between the wall surfaces 16 and the internal portions 26 at the first surface 13.

In the manufacturing process of the through-via substrate 10, a gas may sometimes be generated. For example, a gas is generated from the internal portions 26. The gas is, for example, water vapor. The gas is generated during, for example, a step of heating the components of the through-via substrate 10.

The gas remains in a space inside the through-via substrate 10. For example, the gas remains in gaps between the wall surfaces 16 and the internal portions 26. If the gas continues to stay in such a gap inside the through-via substrate 10, there is a concern that deformation, breakage, or the like may occur inside the through-via substrate 10 due to the pressure of the gas.

In the present modification, the first resin layer 33 overlaps the boundaries between the wall surfaces 16 of the through holes 15 and the internal portions 26 in plan view. The molecular structure of the resin material constituting the first resin layer 33 is larger than the molecular structure of a gas such as water vapor. The gas in the gaps between the wall surfaces 16 and the internal portions 26 is released to the outside of the through-via substrate 10 through the first resin layer 33. Therefore, the occurrence of deformation, breakage, or the like inside the through-via substrate 10 is suppressed.

The plurality of first conductive layers 35 are each located on the first resin layer 33. Each of the plurality of first conductive layers 35 has the outline 351. The outline 351 is the outer edge of the first conductive layer 35 in plan view. As illustrated in Fig. 33, the outline 351 of each of the first conductive layers 35 may surround the first ends 161 of the wall surfaces 16 of the corresponding plurality of through holes 15 in plan view. That is, each of the first conductive layers 35 may have the first ends 161 of the wall surfaces 16 of the corresponding plurality of through holes 15 located inside its outline 351 in plan view.

Each of the first conductive layers 35 may be connected to the corresponding plurality of internal portions 26 in the corresponding plurality of the openings 331. As a result, each of the first conductive layers 35 electrically connects the corresponding plurality of internal portions 26 to each other. The plurality of internal portions 26 electrically connected to each other by the corresponding first conductive layer 35 constitute a corresponding one of the through vias 20.

The plurality of internal portions 26 may also be electrically connected to each other by the at least one conductive layer included in the second wiring layer 50B. The second wiring layer 50B will be described.

The second wiring layer 50B may include the second resin layer 34 and the plurality of second conductive layers 36. The second resin layer 34 is located on the second surface 14. The second resin layer 34 may be in contact with the second surface 14.

The second resin layer 34 has the plurality of openings 341 extending through the second resin layer 34. Each of the plurality of openings 341 of the second resin layer 34 may overlap the corresponding through hole 15 and the corresponding internal portion 26 in plan view.

The second resin layer 34 may overlap the boundaries between the wall surfaces 16 of the through holes 15 and the internal portions 26 in plan view. For example, the second resin layer 34 may overlap the second ends 162 of the wall surfaces 16 in plan view. The second ends 162 define the boundaries between the wall surfaces 16 and the internal portions 26 at the second surface 14.

As in the case of the first resin layer 33, the molecular structure of the resin material constituting the second resin layer 34 is larger than the molecular structure of the gas such as water vapor. The gas in the gaps between the wall surfaces 16 and the internal portions 26 is released to the outside of the through-via substrate 10 through the second resin layer 34. Therefore, the occurrence of deformation, breakage, or the like inside the through-via substrate 10 is suppressed.

The plurality of second conductive layers 36 are each located on the second resin layer 34. The outline 361 of each of the second conductive layers 36 may surround the second ends 162 of the wall surfaces 16 of the corresponding plurality of through holes 15 in plan view. That is, each of the second conductive layers 36 may have the second ends 162 of the wall surfaces 16 of the corresponding plurality of through holes 15 located inside its outline 361 in plan view.

Each of the second conductive layers 36 may be connected to the corresponding plurality of internal portions 26 in the corresponding plurality of openings 341. As a result, the plurality of internal portions 26 are electrically connected to each other by the corresponding second conductive layer 36.

The specific configurations of the internal portions 26 each made of a filled via and the specific configurations of the through holes 15 are not particularly limited. For example, as illustrated in Fig. 34, each of the internal portions 26 and each of the through holes 15 may have a constant dimension regardless of the position in the third direction D3.

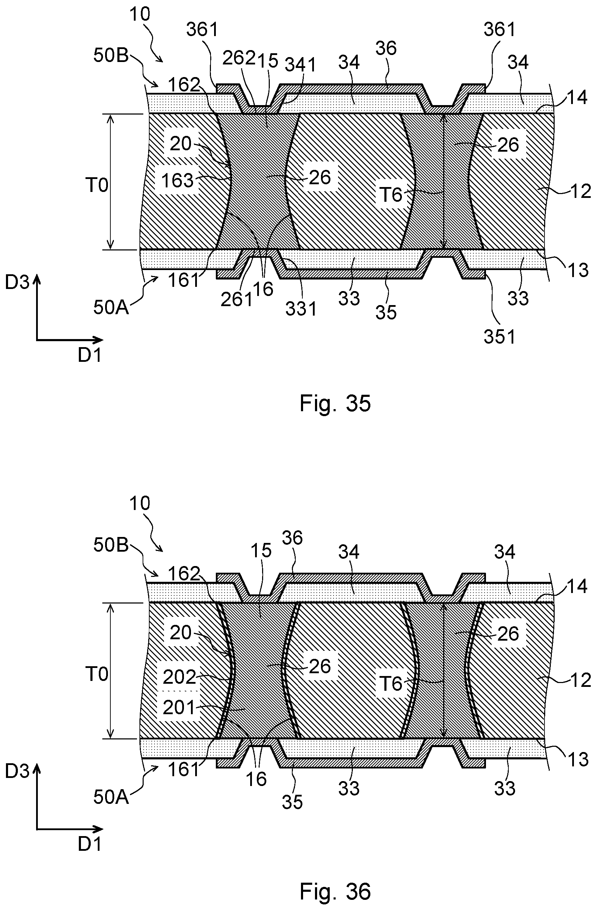

Fig. 35 is a cross-sectional view illustrating an example of the through-via substrate 10. Each of the through holes 15 may have the minimum portion 163. In this case, the dimension of each of the internal portions 26 in the planar direction of the substrate 12 is minimized at the corresponding minimum portion 163.

Fig. 36 is a cross-sectional view illustrating an example of the through-via substrate 10. Each of the internal portions 26 made of a filled via may include the plating layer 201 and the seed layer 202. The plating layer 201 is positioned to overlap the center point of the corresponding through hole 15 in plan view. The seed layer 202 is located between the plating layer 201 and the corresponding wall surface 16.

### (Fourteenth Modification)

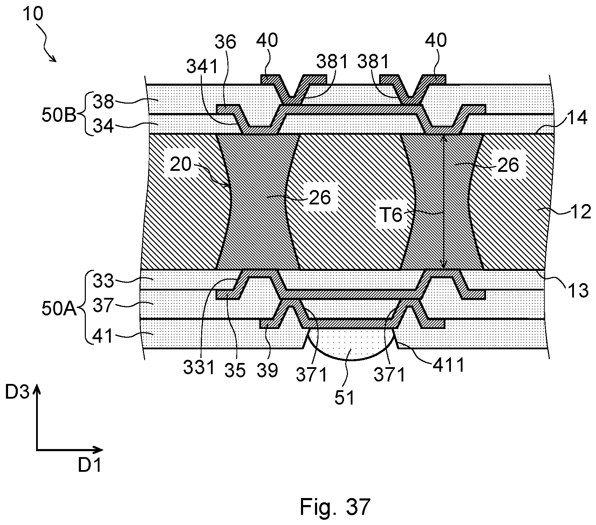

Fig. 37 is a cross-sectional view illustrating the through-via substrate 10 according to the fourteenth modification. The through-via substrate 10 includes the substrate 12, the plurality of through vias 20, the first wiring layer 50A, and the second wiring layer 50B.

The through-via substrate 10 according to the fourteenth modification is different from the through-via substrate 10 according to the thirteenth modification in that the first wiring layer 50A includes a plurality of insulating layers and a plurality of conductive layers stacked in the thickness direction of the substrate 12.

As illustrated in Fig. 37, the first wiring layer 50A may include the first resin layer 33, the third resin layer 37, a fifth resin layer 41, the plurality of first conductive layers 35, and the plurality of third conductive layers 39.

As in the case of the thirteenth modification, each of the first conductive layers 35 may electrically connect the corresponding plurality of internal portions 26 to each other.

The third resin layer 37 is located on the first resin layer 33 and the plurality of first conductive layers 35. The third resin layer 37 has the plurality of openings 371. Each of the plurality of third conductive layers 39 is located on the third resin layer 37. Each of the third conductive layers 39 may be connected to the corresponding first conductive layer 35 in the corresponding opening 371 of the third resin layer 37.

The fifth resin layer 41 is located on the third resin layer 37 and on the third conductive layer 39. The fifth resin layer 41 has at least one opening 411. The opening 411 of the fifth resin layer 41 may overlap the third conductive layer 39 in plan view. In other words, a portion of the third conductive layer 39 may be exposed through the opening 411 of the fifth resin layer 41.

The through-via substrate 10 may include the first bumps 51 each located on the corresponding conductive layer of the first wiring layer 50A. For example, as illustrated in Fig. 37, each of the first bumps 51 may be located on the corresponding third conductive layer 39 in the corresponding opening 411 of the fifth resin layer 41.

Each of the first bumps 51 may be electrically connected to the corresponding plurality of internal portions 26. In the case illustrated in Fig. 37, the first bump 51 is electrically connected to the plurality of internal portions 26 via the third conductive layer 39 and the first conductive layer 35. The through-via substrate 10 may include the plurality of first bumps 51 each electrically connected to the corresponding plurality of internal portions 26.

Although not illustrated, the through-via substrate 10 including the plurality of first bumps 51 may be mounted on a wiring substrate such as a motherboard. For example, each of the plurality of first bumps 51 may be connected to a corresponding one of pads of the wiring substrate.

The dimension in the in-plane direction of the first surface 13 of each opening of the resin layer of the first wiring layer 50A related to an electrical path between each of the first bumps 51 and the corresponding internal portion 26 is preferably 50 µm or more. For example, it is preferable that the dimension of each of the openings 331 of the first resin layer 33 and the dimension of each of the openings 371 of the third resin layer 37 be each 50 µm or more. As a result, the electrical resistance in the path between each of the first bumps 51 and the corresponding internal portions 26 is reduced. Therefore, a sufficient allowable current of each of the first bumps 51 can be achieved.

As illustrated in Fig. 37, the second wiring layer 50B may include the second resin layer 34, a fourth resin layer 38, the second conductive layers 36, and the plurality of fourth conductive layers 40.

As in the case of the thirteenth modification, each of the second conductive layers 36 may electrically connect the corresponding plurality of internal portions 26 to each other.

The fourth resin layer 38 is located on the second resin layer 34 and the second conductive layers 36. The fourth resin layer 38 has a plurality of openings 381. Each of the plurality of fourth conductive layers 40 is located on the fourth resin layer 38. Each of the plurality of fourth conductive layers 40 may be connected to a corresponding one of the second conductive layers 36 in a corresponding one of the plurality of openings 381 of the fourth resin layer 38. The plurality of fourth conductive layers 40 each connected to the corresponding one second conductive layer 36 may be separated from each other in the in-plane direction of the second surface 14.

Although not illustrated, the through-via substrate 10 may include a plurality of second bumps that are located on their respective plurality of fourth conductive layers 40. Although not illustrated, a plurality of terminals of an element may be connected to their respective second bumps.

### (Fifteenth Modification)

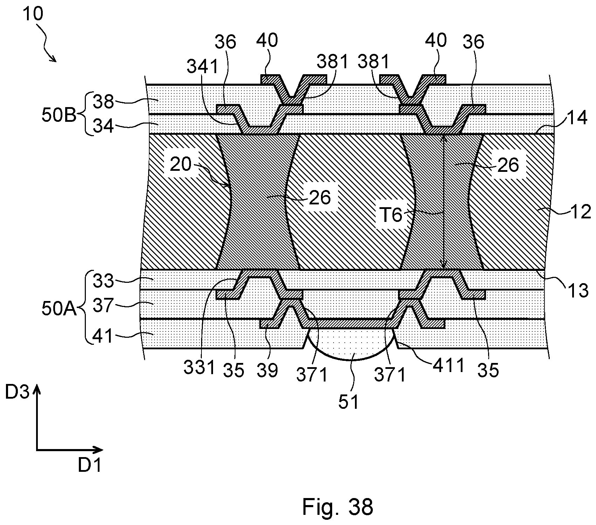

Fig. 38 is a cross-sectional view illustrating the through-via substrate 10 according to the fifteenth modification. The through-via substrate 10 includes the substrate 12, the plurality of through vias 20, the first wiring layer 50A, and the second wiring layer 50B.

As illustrated in Fig. 38, the first wiring layer 50A may include the first resin layer 33, the third resin layer 37, the fifth resin layer 41, the plurality of first conductive layers 35, and the plurality of third conductive layers 39.

The through-via substrate 10 according to the fifteenth modification is different from the through-via substrate 10 according to the fourteenth modification in that each of the third conductive layers 39, instead of each of the first conductive layers 35, electrically connects the corresponding plurality of internal portions 26 to each other.

In the present modification, each of the plurality of first conductive layers 35 is connected to one of the internal portions 26 in one of the openings 331 of the first resin layer 33. For example, the four first conductive layers 35 are each connected to one of the internal portions 26 in a corresponding one of the four openings 331. The plurality of first conductive layers 35 are separated from each other in the in-plane direction of the first surface 13. Therefore, the plurality of internal portions 26 are not electrically connected to each other by the first conductive layers 35.

The third resin layer 37 is located on the first resin layer 33 and the plurality of first conductive layers 35. The third resin layer 37 has the plurality of openings 371. The plurality of openings 371 overlap their respective first conductive layers 35. Each of the third conductive layers 39 is connected to the corresponding plurality of first conductive layers 35 in the corresponding plurality of openings 371. As a result, each of the third conductive layers 39 electrically connects the corresponding plurality of internal portions 26 to each other. Also in the present modification, the plurality of internal portions 26 electrically connected to each other constitute one of the through vias 20. That is, a multi-via structure is also employed in the present modification.

The through-via substrate 10 may include the plurality of through vias 20, as in the above-described embodiment and modifications. Each of the plurality of through vias 20 may include the plurality of internal portions 26 that are electrically connected to each other by the third conductive layers 39.

The conductive layers of the first wiring layer 50A each of which electrically connects the corresponding plurality of internal portions 26 to each other may be conductive layers other than the third conductive layers 39. For example, although not illustrated, a fifth conductive layer located on the fifth resin layer 41 may electrically connect the plurality of internal portions 26.

The dimension in the in-plane direction of the first surface 13 of each opening of the resin layer of the first wiring layer 50A related to the electrical path between each of the first bumps 51 and the corresponding plurality of internal portions 26 is preferably 50 µm or more. For example, it is preferable that the dimension of each of the openings 331 of the first resin layer 33 and the dimension of each of the openings 371 of the third resin layer 37 be each 50 µm or more. As a result, the electrical resistance in the path between each of the first bumps 51 and the corresponding plurality of internal portions 26 is reduced. Therefore, a sufficient allowable current of each of the first bumps 51 can be achieved.

As illustrated in Fig. 38, the second wiring layer 50B may include the second resin layer 34, the fourth resin layer 38, the plurality of second conductive layers 36, and the plurality of fourth conductive layers 40.

Each of the plurality of second conductive layers 36 may be connected to a corresponding one of the internal portions 26 in a corresponding one of the openings 341 of the second resin layer 34. The plurality of second conductive layers 36 may be separated from each other in the in-plane direction of the second surface 14. In this case, the plurality of internal portions 26 are not electrically connected to each other by the second conductive layers 36.

Each of the plurality of fourth conductive layers 40 may be connected to a corresponding one of the second conductive layers 36 in a corresponding one of the openings 381 of the fourth resin layer 38. The plurality of fourth conductive layers 40 may be separated from each other in the in-plane direction of the second surface 14. In this case, the plurality of internal portions 26 are not electrically connected to each other by the fourth conductive layers 40, either.

Although some modifications of the above-described embodiment have been described, it is natural that a plurality of modifications may be appropriately combined and applied to the above-described embodiment.

### EXAMPLES

Next, the embodiments of the present disclosure will be described more specifically by way of examples, but the embodiments of the present disclosure are not limited to the descriptions of the following examples unless they depart from the gist thereof.

### (Example 1-1)

As the substrate 12, a glass substrate having the thickness T0 of 800 µm was prepared. Subsequently, the plurality of through holes 15 illustrated in Fig. 4 were formed in the substrate 12. Each of the through holes 15 has the first end 161 having the first dimension R1, the second end 162 having the second dimension R2, and the minimum portion 163 having the minimum dimension R3. The first end 161, the second end 162, and the minimum portion 163 each have a circular outline in plan view. The first dimension R1, the second dimension R2, and the minimum dimension R3 were 85 µm, 85 µm, and 50 µm, respectively.

Subsequently, the plurality of through vias 20 and the plurality of internal resins 30 illustrated in Fig. 4 were formed in the substrate 12. Each of the plurality of through vias 20 includes the plating layer 201 and the seed layer 202, each made of copper. Each of the plurality of through vias 20 includes one first portion 21, one second portion 22, and four internal portions 26. Each of the internal portions 26 includes a third portion 23, a fourth portion 24, and the closing portion 25. The thickness T3 of the third portion 23 and the thickness T4 of the fourth portion 24 were both 20 µm. The distance from the first surface 13 to the first closing surface 251 of the closing portion 25 in the thickness direction of the substrate 12, that is, the first distance K1, was 150 µm. The distance from the second surface 14 to the second closing surface 252 of the closing portion 25 in the thickness direction of the substrate 12, that is, the second distance K2, was 150 µm. The thickness T5 of the closing portion 25 in the thickness direction of the substrate 12 was 500 µm. The second pitch P2 of the plurality of through holes 15 overlapping the first portion 21 of one of the through vias 20 was 100 µm.

The reliability of the through-via substrate 10 of Example 1-1 was evaluated.

In the evaluation of reliability, the appearance of the through-via substrate 10 is observed after applying 1000 thermal cycles to the through-via substrate 10. Specifically, it is checked whether a defect such as a crack has occurred in the appearances of the through vias 20 of the through-via substrate 10. When a defect such as a crack has occurred, the through-via substrate 10 to be evaluated is determined to be "NG". When a defect such as a crack has not occurred, the appearance of the through-via substrate 10 is observed after the through-via substrate 10 is further subjected to 1000 thermal cycles. After a total of 2000 thermal cycles, when a defect such as a crack occurs, the through-via substrate 10 to be evaluated is determined to be "Good". After a total of 2000 thermal cycles, when a defect such as a crack has not occurred, the through-via substrate 10 to be evaluated is determined to be "Excellent".

Each thermal cycle includes a temperature raising step, a high-temperature holding step, a temperature lowering step, and a low-temperature holding step. The temperature raising step is a step of changing the ambient environment of the through-via substrate 10 from -55°C to +125°C in 30 minutes. The high-temperature holding step is a step of holding the ambient environment of the through-via substrate 10 at +125°C for 30 minutes. The temperature lowering step is a step of changing the ambient environment of the through-via substrate 10 from +125°C to -55°C in 30 minutes. The low-temperature holding step is a step of holding the ambient environment of the through-via substrate 10 at -55°C for 30 minutes.

In the through-via substrate 10 of Example 1-1, a defect such as a crack was generated after 1000 thermal cycles. The through-via substrate 10 of Example 1-1 is determined to be "NG".

### (Examples 1-2 to 1-9)

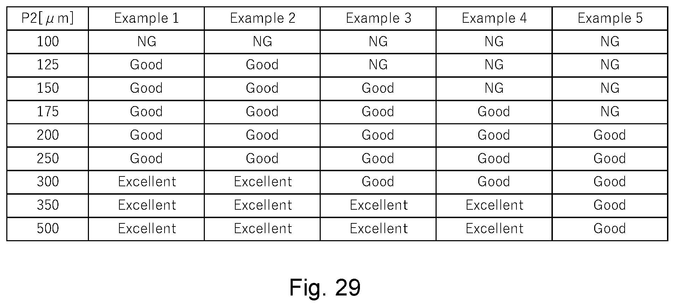

The through-via substrate 10 was fabricated by changing the second pitch P2 of the plurality of through holes 15 from the value in Example 1-1. Subsequently, as in the case of Example 1-1, the reliability of the through-via substrate 10 was evaluated. The results are illustrated in Fig. 29.

### (Example 2-1)

As the substrate 12, a glass substrate having the thickness T0 of 400 µm was prepared. Subsequently, the plurality of through holes 15 illustrated in Fig. 15 were formed in the substrate 12. Each of the through holes 15 has the first end 161 having the first dimension R1, the second end 162 having the second dimension R2, and the minimum portion 163 having the minimum dimension R3. The first end 161, the second end 162, and the minimum portion 163 each have a circular outline in plan view. The first dimension R1, the second dimension R2, and the minimum dimension R3 were 85 µm, 85 µm, and 70 µm, respectively.

Subsequently, the plurality of through vias 20 and the plurality of internal resins 30 illustrated in Fig. 15 were formed in the substrate 12. Each of the plurality of through vias 20 includes the plating layer 201 and the seed layer 202, each made of copper. Each of the plurality of through vias 20 includes one first portion 21, one second portion 22, and four internal portions 26. Each of the internal portions 26 is located on the wall surface 16 such that it extends from the first end 161 to the second end 162. The thickness of each of the internal portions 26 was 20 µm. The second pitch P2 of the plurality of through holes 15 overlapping the first portion 21 of one of the through vias 20 was 100 µm.

As in the case of Example 1-1, the reliability of the through-via substrate 10 was evaluated. The results are illustrated in Fig. 29.

### (Examples 2-2 to 2-9)

The through-via substrate 10 was fabricated by changing the second pitch P2 of the plurality of through holes 15 from the value in Example 2-1. Subsequently, as in the case of Example 1-1, the reliability of the through-via substrate 10 was evaluated. The results are illustrated in Fig. 29.

### (Example 3-1)

As the substrate 12, a glass substrate having the thickness T0 of 400 µm was prepared. Subsequently, the plurality of through holes 15 illustrated in Fig. 16 were formed in the substrate 12. Each of the through holes 15 has the first end 161 having the first dimension R1 and the second end 162 having the second dimension R2. The first end 161 and the second end 162 each have a circular outline in plan view. The first dimension R1 and the second dimension R2 were 85 µm and 85 µm, respectively.

Subsequently, the plurality of through vias 20 and the plurality of internal resins 30 illustrated in Fig. 16 were formed in the substrate 12. Each of the plurality of through vias 20 includes the plating layer 201 and the seed layer 202, each made of copper. Each of the plurality of through vias 20 includes one first portion 21, one second portion 22, and four internal portions 26. Each of the internal portions 26 is located on the wall surface 16 such that it extends from the first end 161 to the second end 162. The thickness of each of the internal portions 26 was 20 µm. The second pitch P2 of the plurality of through holes 15 overlapping the first portion 21 of one of the through vias 20 was 100 µm.

As in the case of Example 1-1, the reliability of the through-via substrate 10 was evaluated. The results are illustrated in Fig. 29.

### (Examples 3-2 to 3-9)

The through-via substrate 10 was fabricated by changing the second pitch P2 of the plurality of through holes 15 from the value in Example 3-1. Subsequently, as in the case of Example 1-1, the reliability of the through-via substrate 10 was evaluated. The results are illustrated in Fig. 29.

### (Example 4-1)

As the substrate 12, a glass substrate having the thickness T0 of 500 µm was prepared. Subsequently, the plurality of through holes 15 illustrated in Fig. 17 were formed in the substrate 12. Each of the through holes 15 has the first end 161 having the first dimension R1, the second end 162 having the second dimension R2, and the minimum portion 163 having the minimum dimension R3. The first end 161, the second end 162, and the minimum portion 163 each have a circular outline in plan view. The first dimension R1, the second dimension R2, and the minimum dimension R3 were 85 µm, 85 µm, and 50 µm, respectively.

Subsequently, the plurality of through vias 20 illustrated in Fig. 17 were formed in the substrate 12. Each of the plurality of through vias 20 includes the plating layer 201 and the seed layer 202, each made of copper. Each of the plurality of through vias 20 includes one first portion 21, one second portion 22, and four internal portions 26. Each of the internal portions 26 occupies the entire space of the corresponding through hole 15. The second pitch P2 of the plurality of through holes 15 overlapping the first portion 21 of one of the through vias 20 was 100 µm.

As in the case of Example 1-1, the reliability of the through-via substrate 10 was evaluated. The results are illustrated in Fig. 29.

### (Examples 4-2 to 4-9)

The through-via substrate 10 was fabricated by changing the second pitch P2 of the plurality of through holes 15 from the value in Example 4-1. Subsequently, as in the case of Example 1-1, the reliability of the through-via substrate 10 was evaluated. The results are illustrated in Fig. 29.

### (Example 5-1)

As the substrate 12, a glass substrate having the thickness T0 of 600 µm was prepared. Subsequently, the plurality of through holes 15 illustrated in Fig. 18 were formed in the substrate 12. Each of the through holes 15 has the first end 161 having the first dimension R1 and the second end 162 having the second dimension R2. The first end 161 and the second end 162 each have a circular outline in plan view. The first dimension R1 and the second dimension R2 were 50 µm and 50 µm, respectively.

Subsequently, the plurality of through vias 20 illustrated in Fig. 18 were formed in the substrate 12. Each of the plurality of through vias 20 includes the plating layer 201 and the seed layer 202, each made of copper. Each of the plurality of through vias 20 includes one first portion 21, one second portion 22, and four internal portions 26. Each of the internal portions 26 occupies the entire space of the corresponding through hole 15. The second pitch P2 of the plurality of through holes 15 overlapping the first portion 21 of one of the through vias 20 was 100 µm.

As in the case of Example 1-1, the reliability of the through-via substrate 10 was evaluated. The results are illustrated in Fig. 29.

### (Examples 5-2 to 5-9)

The through-via substrate 10 was fabricated by changing the second pitch P2 of the plurality of through holes 15 from the value in Example 5-1. Subsequently, as in the case of Example 1-1, the reliability of the through-via substrate 10 was evaluated. The results are illustrated in Fig. 29.

In the through vias 20 illustrated in Fig. 4 or Fig. 15, the second pitch P2 is preferably 125 µm or more, and the second pitch P2 is more preferably 300 µm or more. In the through vias 20 illustrated in Fig. 16, the second pitch P2 is preferably 150 µm or more, and the second pitch P2 is more preferably 350 µm or more. In the through vias 20 illustrated in Fig. 17, the second pitch P2 is preferably 175 µm or more, and the second pitch P2 is more preferably 350 µm or more. In the through vias 20 illustrated in Fig. 18, the second pitch P2 is preferably 200 µm or more.

### (Example 6)

The through-via substrate 10 was designed to include a filled via having a single via structure formed by the through hole 15 not including the minimum portion 163, and a copper plate located on the surface of the substrate 12. The substrate 12 is made of FR4 and has the thickness T0 of 400 µm. The copper plate has a width of 0.5 mm and a thickness of 18 µm. Subsequently, a simulation simulating heat dissipation of the through-via substrate 10 was performed. In the simulation, the finite element method was used. In the simulation, it was assumed that heat was released by convection on a surface of the copper plate. The heat flux equation is as follows: $q = h \left({T}_{Cu}-{T}_{air}\right)$ q is the heat flux. The unit of the heat flux q is W/m². h is the thermal conductivity in convection. The unit of the thermal conductivity h is W/m²·K. T_{Cu} is the temperature of the copper plate. Tₐᵢᵣ is the temperature of the air. As the value of the thermal conductivity h, 373 [W/m²·K] was used. This value was calculated based on the heat dissipation characteristics of the wiring substrate described in JIS C 5012:1993. Specifically, in the test described in JIS C 5012:1993, when a copper plate having a width of 0.6 mm and a thickness of 18 µm is placed on a substrate and a direct current of 1 A is passed through the copper plate, a temperature rise of 10°C occurs. When this test result is applied to the above equation of the heat flux, a value of the thermal conductivity h of 373 [W/m²·K] is calculated. Other conditions in the simulation are as follows.
· Thermal conductivity of copper: 400 [W/m·K]
· Resistivity of copper: 1.68×10⁻⁸ [Ω·m]
· Thermal conductivity of FR4: 0.3 [W/m·K]

Based on the simulation, the first dimension R1 and the second dimension R2 when the through-via substrate 10 of Example 6 satisfies the above-described current withstand property condition were calculated. When the first dimension R1 and the second dimension R2 were each 94 µm, the temperature rise was 10°C, and the value of the current flowing through the copper plate and the filled via was 0.96 A. Therefore, when the first dimension R1 and the second dimension R2 are each 94 µm or more, it is presumed that the above-mentioned current withstand property condition is satisfied.

In the case where a multi-via structure is employed, even when the first dimension R1 and the second dimension R2 are each less than 94 µm, it is presumed that the above-mentioned current withstand property condition is satisfied.

A simulation was performed under the conditions where the first dimension R1 and the second dimension R2 were each 94 µm, the value of the current flowing through the copper plate and the filled via was 0.96 A, and the temperature of the through-via substrate 10 was 260°C. Based on this simulation, the thermal stress generated between the substrate 12 and the filled via was calculated. The thermal stress reached a maximum value of 187 MPa at the first end 161 of the through hole 15.

### (Example 7)

The through-via substrate 10 was designed to include a conformal via having a single via structure formed by the through hole 15 not including the minimum portion 163, and a copper plate located on the surface of the substrate 12.

As in the case of Example 6, the first dimension R1, the second dimension R2, and the thickness of the internal portion 26 when the through-via substrate 10 of Example 7 satisfies the above-described current withstand property condition were calculated based on the simulation. When the first dimension R1 and the second dimension R2 were each 104 µm and the internal portion 26 had a thickness of 30 µm, the temperature rise was 10°C, and the value of the current flowing through the copper plate and the conformal via was 0.97 A. Therefore, when the first dimension R1 and the second dimension R2 are each 104 µm or more and the thickness of the internal portion 26 is 30 µm or more, it is presumed that the above-described current withstand property condition is satisfied.

In the case where a multi-via structure is employed, it is presumed that the above-described current withstand property condition is satisfied even when the first dimension R1 and the second dimension R2 are each less than 104 µm and the thickness of the internal portion 26 is less than 30 µm.

A simulation was performed under the conditions where the first dimension R1 and the second dimension R2 were each 104 µm, the thickness of the internal portion 26 was 30 µm, the value of the current flowing through the copper plate and the conformal via was 0.97 A, and the temperature of the through-via substrate 10 was 260°C. Based on this simulation, the thermal stress generated between the substrate 12 and the conformal via was calculated. The thermal stress reached a maximum value of 171 MPa at the first end 161 of the through hole 15.

### (Example 8)

The through-via substrate 10 was designed to include a through via having a single via structure formed by the through hole 15 including the minimum portion 163, and a copper plate located on the surface of the substrate 12. The through via includes the internal portion 26 illustrated in Fig. 4.

As in the case of Example 6, the first dimension R1, the second dimension R2, the minimum dimension R3, and the thickness of the internal portion 26 when the through-via substrate 10 of Example 8 satisfies the above-described current withstand property condition were calculated based on the simulation. When the first dimension R1 and the second dimension R2 were each 180 µm, the minimum dimension R3 was 60 µm, and the thicknesses T3 and T4 of the internal portion 26 were each 30 µm, the temperature rise was 10°C, and the value of the current flowing through the copper plate and the conformal via was 0.96 A. Therefore, when the first dimension R1 and the second dimension R2 are each 180 µm or more, the minimum dimension R3 is 60 µm or more, and the thicknesses T3 and T4 of the internal portion 26 are each 30 µm or more, it is presumed that the above-described current withstand property condition is satisfied.

In the case where a multi-via structure is employed, even when the first dimension R1 and the second dimension R2 are each less than 180 µm, the minimum dimension R3 is less than 60 µm, and the thicknesses T3 and T4 are each less than 30 µm, it is presumed that the above-described current withstand property condition is satisfied.

A simulation was performed under the conditions where the first dimension R1 and the second dimension R2 were each 180 µm or more, the minimum dimension R3 was 60 µm or more, the thicknesses T3 and T4 of the internal portion 26 were each 30 µm or more, the value of the current flowing through the copper plate and the conformal via was 0.96 A, and the temperature of the through-via substrate 10 was 260°C. Based on this simulation, the thermal stress generated between the substrate 12 and the through via was calculated. The thermal stress reached a maximum value of 93 MPa at the first end 161 of the through hole 15.

The maximum value of the thermal stress in Example 8 was about half of each of the maximum values of the thermal stress in Examples 6 and 7. In the case illustrated in Example 8, it is considered that, since the through hole 15 includes the minimum portion 163, the angle θ1 and the angle θ2 are each larger than 90° and that the thermal stress is reduced.

### (Example 9)

The through-via substrate 10 was designed to include through vias each having a multi-via structure formed by the through holes 15 including the minimum portion 163, and a copper plate located on the surface of the substrate 12. One of the through vias 20 includes the four internal portions 26 illustrated in Fig. 4. The second pitch P2 of the four through holes 15 was 250 µm.

As in the case of Example 6, the first dimension R1, the second dimension R2, the minimum dimension R3, and the thickness of each of the internal portions 26 when the through-via substrate 10 of Example 9 satisfied the above-described current withstand property condition were calculated based on the simulation. In the case where the first dimension R1 and the second dimension R2 were each 70 µm, the minimum dimension R3 was 35 µm, and the thicknesses T3 and T4 of each of the internal portions 26 were each 30 µm, the above-described current withstand property condition was satisfied. Therefore, in the case where the through via 20 includes the four or more internal portions 26, the first dimension R1 and the second dimension R2 are each 70 µm or more, the minimum dimension R3 is 35 µm or more, and the thicknesses T3 and T4 of each of the internal portions 26 are 30 µm or more, it is presumed that the above-described current withstand property condition is satisfied.

### Reference Signs List

10 through-via substrate
12 substrate
13 first surface
14 second surface
15 through hole
16 wall surface
161 first end
162 second end
163 minimum portion
20 through via
201 plating layer
202 seed layer
21 first portion
211 outline
212 opening
22 second portion
23 third portion
24 fourth portion
25 closing portion
26 internal portion
30 internal resin
31 first internal resin
32 second internal resin
33 first resin layer
331 opening
34 second resin layer
35 first conductive layer
351 outline
36 second conductive layer
37 third resin layer
38 fourth resin layer
39 third conductive layer
40 fourth conductive layer
41 fifth resin layer
50A first wiring layer
50B second wiring layer
51 first bump
52 second bump
60 element
61 terminal
70 capacitor
81 first resist layer
82 second resist layer

## Claims

1. A through-via substrate comprising:
a substrate having a first surface, a second surface located opposite to the first surface, and a plurality of through holes extending from the first surface to the second surface; and
a plurality of through vias extending from the first surface to the second surface through the through holes,
wherein each of the plurality of through vias includes a plurality of internal portions located inside a respective plurality of the through holes, a first portion located at the first surface and connected to the plurality of internal portions, and a second portion located at the second surface and connected to the plurality of internal portions, and
wherein each of the first portions of the plurality of through vias has an outline surrounding the respective plurality of through holes in plan view.

2. The through-via substrate according to claim 1,
wherein each of the plurality of through holes has a wall surface having a first end connected to the first surface, a second end connected to the second surface, and a minimum portion located between the first end and the second end,
wherein each of the plurality of through holes has a minimum dimension at the minimum portion, the minimum dimension being a minimum value of a dimension of the through hole in a planar direction of the first surface, and
wherein each of the plurality of internal portions includes a closing portion that closes the through hole at least at the minimum portion, a third portion located on the wall surface between the first portion and the closing portion, and a fourth portion located on the wall surface between the second portion and the closing portion.

3. The through-via substrate according to claim 2,
wherein the closing portion has a first closing surface and a second closing surface,
wherein the first closing surface is a surface of the closing portion, the surface facing toward the first surface,
wherein the second closing surface is a surface of the closing portion, the surface facing toward the second surface,
wherein the through via has a first distance that is a maximum value of a distance from the first surface to the first closing surface in a thickness direction of the substrate, and a second distance that is a maximum value of a distance from the second surface to the second closing surface in the thickness direction of the substrate,
wherein a ratio of the first distance to a thickness of the substrate is 0.10 or more, and
wherein a ratio of the second distance to a thickness of the substrate is 0.10 or more.

4. The through-via substrate according to claim 2, comprising a plurality of internal resins located inside each of the plurality of through holes,
wherein each of the plurality of internal resins includes a first internal resin located inside the third portion and a second internal resin located inside the fourth portion.

5. The through-via substrate according to claim 1,
wherein each of the plurality of through holes has a wall surface having a first end connected to the first surface and a second end connected to the second surface,
wherein each of the plurality of internal portions is located on the wall surface so as to extend from the first end to the second end, and
wherein the through-via substrate includes a plurality of internal resins located inside a respective one of the plurality of internal portions of the through via in each of the plurality of through holes.

6. The through-via substrate according to claim 5,
wherein each of the plurality of through holes includes a minimum portion located between the first end and the second end, and
wherein each of the plurality of through holes has a minimum dimension at the minimum portion, the minimum dimension being a minimum value of a dimension of the through hole in a planar direction of the first surface.

7. The through-via substrate according to any one of claims 4 to 6,
wherein the first portion of each of the plurality of through vias has a plurality of openings in which the internal resins are located.

8. The through-via substrate according to claim 1,
wherein a ratio of a thickness of the internal portion to a thickness of the substrate is 0.80 or more and 1.20 or less.

9. The through-via substrate according to any one of claims 1 to 6 and 8, comprising:
a plurality of first conductive layers connected respectively to the first portions of the plurality of through vias; and
a first resin layer located between the first portions of the plurality of through vias and the plurality of first conductive layers in a thickness direction of the substrate.

10. The through-via substrate according to claim 9,
wherein each of the plurality of first conductive layers has an outline surrounding the respective plurality of through holes in plan view.

11. The through-via substrate according to claim 10, comprising:
a plurality of third conductive layers connected to one of the plurality of first conductive layers; and
a third resin layer located between one of the plurality of first conductive layers and the plurality of third conductive layers in the thickness direction of the substrate.

12. The through-via substrate according to claim 10,
wherein the plurality of through vias include a first through via and a second through via adjacent to the first through via in plan view,
wherein one of the first conductive layers connected to the first through via extends outward beyond the outline of the first portion of the first through via,
wherein the first portion of the second through via extends outward beyond the outline of another one of the first conductive layers connected to the second through via, and
wherein a portion of the first conductive layer connected to the first through via and a portion of the first portion of the second through via face each other in the thickness direction of the substrate.

13. The through-via substrate according to claim 9,
wherein the first resin layer has an opening in which a portion of the first conductive layer is located, the opening having a fourth dimension in plan view,
wherein the through hole has a first dimension at the first surface, and
wherein the fourth dimension is greater than the first dimension.

14. A through-via substrate comprising:
a substrate having a first surface, a second surface located opposite to the first surface, and a plurality of through holes extending from the first surface to the second surface;
a plurality of through vias extending from the first surface to the second surface through the through holes; and
a first wiring layer located at the first surface and including at least one insulating layer and at least one conductive layer,
wherein each of the plurality of through vias includes a plurality of internal portions located inside a respective plurality of the through holes,
wherein a ratio of a thickness of the internal portion to a thickness of the substrate is 0.80 or more and 1.20 or less,
wherein the at least one insulating layer includes a first resin layer located on the first surface,
wherein the first resin layer has a plurality of openings, each of the plurality of openings overlapping the internal portion in plan view,
wherein the first resin layer overlaps a boundary between a wall surface of the through hole and the internal portion in plan view, and
wherein the at least one conductive layer includes a conductive layer electrically connected to the plurality of internal portions.

15. The through-via substrate according to claim 14,
wherein the at least one conductive layer includes a first conductive layer connected to the plurality of internal portions in the plurality of openings of the first resin layer, and
wherein the first conductive layer is the conductive layer electrically connected to the plurality of internal portions.

16. The through-via substrate according to claim 14,
wherein the at least one conductive layer includes a plurality of first conductive layers each connected to a respective one of the plurality of internal portions in a respective one of the plurality of openings of the first resin layer, and the conductive layer, which is electrically connected to the plurality of first conductive layers.

17. The through-via substrate according to any one of claims 1 to 6, 8, and 14 to 16,
wherein the plurality of through vias are arranged at a first pitch in a planar direction of the first surface,
wherein the respective through holes in which the plurality of internal portions included in one of the through vias are located are arranged at a second pitch in a planar direction of the first surface, and
wherein a ratio of the first pitch to the second pitch is 2.0 or more.

18. The through-via substrate according to claim 17,
wherein the ratio of the first pitch to the second pitch is 5.0 or less.

19. The through-via substrate according to claim 17,
wherein the through hole has a first dimension at the first surface, and
wherein a ratio of the second pitch to the first dimension is 1.5 or more.

20. The through-via substrate according to claim 19,
wherein the first dimension is 50 µm or more and 100 µm or less.

21. A mounting substrate comprising:
the through-via substrate according to any one of claims 1 to 6, 8, and 14 to 16; and
an element electrically connected to the plurality of through vias of the through-via substrate.

22. A method of manufacturing a through-via substrate, comprising:
a step of preparing a substrate having a first surface, a second surface located opposite to the first surface, and a plurality of through holes extending from the first surface to the second surface; and
a through-via forming step of forming a plurality of through vias extending from the first surface to the second surface through the through holes,
wherein each of the plurality of through vias includes a plurality of internal portions located inside a respective plurality of the through holes, a first portion located at the first surface and connected to the plurality of internal portions, and a second portion located at the second surface and connected to the plurality of internal portions, and
wherein each of the first portions of the plurality of through vias has an outline surrounding the respective plurality of through holes in plan view.

23. A method of manufacturing a through-via substrate, comprising:
a step of preparing a substrate having a first surface, a second surface located opposite to the first surface, and a plurality of through holes extending from the first surface to the second surface;
a through-via forming step of forming a plurality of through vias extending from the first surface to the second surface through the through holes; and
a step of forming a first wiring layer that is located at the first surface and that includes at least one insulating layer and at least one conductive layer,
wherein each of the plurality of through vias includes a plurality of internal portions located inside a respective plurality of the through holes,
wherein each of the plurality of internal portions is a filled via,
wherein the at least one insulating layer includes a first resin layer located on the first surface,
wherein the first resin layer has a plurality of openings, each of the plurality of openings overlapping the internal portion in plan view,
wherein the first resin layer overlaps a boundary between a wall surface of the through hole and the internal portion in plan view, and
wherein the at least one conductive layer includes a conductive layer electrically connected to the plurality of internal portions.
